(19) Europäisches Patentamt
European Patent Office
Office européen des brevets

(11) **EP 4 447 612 A1**

(12) **EUROPEAN PATENT APPLICATION**

(43) Date of publication:
**16.10.2024 Bulletin 2024/42**

(21) Application number: **24165440.9**

(22) Date of filing: **22.03.2024**

(51) International Patent Classification (IPC):
***H05B 1/02*** (2006.01)

(52) Cooperative Patent Classification (CPC):
**H05B 1/0244**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.03.2023 US 202318194115**

(71) Applicant: **Chromalox, Inc.
Pittsburgh, PA 15238 (US)**

(72) Inventors:
• **LEWIS, James
Pittsburgh, 15238 (US)**
• **TRUSSLER, Richard
Pittsburgh, 15238 (US)**
• **WHEELER, Mark
Pittsburgh, 15238 (US)**

(74) Representative: **Haseltine Lake Kempner LLP
One Portwall Square
Portwall Lane
Bristol BS1 6BH (GB)**

(54) **A METHOD OF ASSESSING A CONDITION OF A HEATING ARRANGEMENT**

(57) The present disclosure relates to a method 200, 200' of assessing a condition of a heating arrangement 130 for heating a process medium 140, the method 200, 200' comprising: monitoring 210 a voltage supplied to the heating arrangement 130 by a power supply 110 using a voltage sensing arrangement 182; monitoring 220 a current drawn by the heating arrangement 130 using a current sensing arrangement 184; storing 260, 270, 270' information relating to the monitored current and the monitored voltage; and assessing 280, 290, 290' the condition of the heating arrangement based on the stored information relating to the monitored current and the monitored voltage.

FIG. 5

EP 4 447 612 A1

**Description**

FIELD OF THE INVENTION

The present disclosure relates to a method of assessing a condition of a heating arrangement for heating a process medium. It relates further to a system comprising a heating arrangement for heating a process medium and a data processing apparatus configured to assess a condition of the heating arrangement.

BACKGROUND TO THE INVENTION

In industrial processes, it may be necessary to heat a process medium such as oil, gas or another process fluid, or a solid process medium. In particular, heating of the process medium may be to maintain the process medium at a target temperature or within a target temperature range. In such industrial processes a system including an electric heating arrangement may be used for heating the process medium.

It is desirable to provide a method for assessing a condition of such a heating arrangement to, for instance, facilitate carrying out appropriate maintenance and/or scheduling timely replacement of the heating arrangement.

SUMMARY OF THE INVENTION

According to a first aspect there is provided a method of assessing a condition of a heating arrangement for heating a process medium, the method comprising:

   monitoring a voltage supplied to the heating arrangement by a power supply using a voltage sensing arrangement;
   monitoring a current drawn by the heating arrangement using a current sensing arrangement;
   storing information relating to the monitored current and the monitored voltage; and
   assessing the condition of the heating arrangement based on the stored information relating to the monitored current and the monitored voltage.

It may be that the heating arrangement comprises a plurality of heating components, each heating component being configured to receive a respective phase of a polyphase periodic AC electrical power supplied by a power supply, and the method comprises:

   monitoring a voltage supplied to each heating component by the power supply using the voltage sensing arrangement;
   monitoring a current drawn by each heating component using the current sensing arrangement;
   storing information relating to the monitored current and the monitored voltage for each heating component; and
   assessing the condition of each heating component based on the stored information relating to the monitored current and the monitored voltage.

The heating arrangement may comprise a heating component which includes a heating element, and assessing the condition of the heating arrangement based on the stored information relating to the monitored current and the monitored voltage may include: inferring a condition of the heating element based on the stored information relating to the monitored current and the monitored voltage.

Inferring the condition of the heating element based on the stored information relating to the monitored current and the monitored voltage may include: estimating a remaining service life of the heating arrangement based on the stored information relating to the monitored current and the monitored voltage.

The heating arrangement may comprise a heating component which includes a heating element at least partially surrounded by an electrically insulating sheath, and assessing the condition of the heating arrangement based on the stored information relating to the monitored current and the monitored voltage may include: inferring a condition of the electrically insulating sheath based on the stored information relating to the calculated reactance.

Inferring the condition of the electrically insulating sheath based on the stored information relating to the monitored current and the monitored voltage may include: estimating a remaining service life of the heating arrangement based on the stored information relating to the monitored current and the monitored voltage.

It may be that the condition of the heating arrangement is associated with: a structural integrity of the heating arrangement; a material degradation of the heating arrangement; and/or a material corrosion of the heating arrangement.

Further, it may be that assessing the condition of the heating arrangement includes determining whether a compromised condition criterion has been met and generating an alarm indicative of the heating arrangement being in a compromised condition in response to a determination that the compromised condition criterion has been met.

According to a second aspect there is provided a method of assessing a condition of a heating arrangement for heating a process medium, the method comprising:

> monitoring a voltage supplied to the heating arrangement by a power supply using a voltage sensing arrangement;
> monitoring a current drawn by the heating arrangement using a current sensing arrangement;
> calculating a resistance of the heating arrangement based on the monitored current and the monitored voltage;
> storing information relating to the calculated resistance of the heating arrangement; and
> assessing the condition of the heating arrangement based on the stored information relating to the calculated resistance.

It may be that the heating arrangement comprises a plurality of heating components, each heating component being configured to receive a respective phase of a polyphase periodic AC electrical power supplied by a power supply, and the method comprises:

> monitoring a voltage supplied to each heating component by the power supply using the voltage sensing arrangement;
> monitoring a current drawn by each heating component using the current sensing arrangement;
> calculating a resistance of each heating component based on the respective monitored current and the respective monitored voltage;
> storing information relating to the calculated resistance of each heating component; and

assessing the condition of each heating component based on the stored information relating to the calculated resistance.

The heating arrangement may comprise a heating component which includes a heating element, and assessing the condition of the heating arrangement based on the stored information relating to the calculated resistance may include: inferring a condition of the heating element based on the stored information relating to the calculated resistance.

Inferring the condition of the heating element based on the stored information relating to the calculated resistance may include: estimating a remaining service life of the heating arrangement based on the stored information relating to the calculated resistance.

Assessing the condition of the heating arrangement based on the stored information relating to the calculated resistance may include:

> calculating a rate of change of the resistance of the heating arrangement based on the stored information relating to the calculated resistance; and
> analysing the calculated rate of change of the resistance of the heating arrangement to assess the condition of the heating arrangement.

Assessing the condition of the heating arrangement based on the stored information relating to the calculated resistance may include:

> comparing the calculated resistance of the heating arrangement to an upper resistance threshold; and
> determining that a compromised condition criterion has been met if the calculated resistance is greater than the upper resistance threshold

Additionally or alternatively, assessing the condition of the heating arrangement based on the stored information relating to the calculated resistance may include:

> comparing the calculated resistance of the heating arrangement to a lower resistance threshold; and
> determining that a compromised condition criterion has been met if the calculated resistance is less than the lower resistance threshold.

Analysing the calculated rate of change of the resistance of the heating arrangement to assess the condition of the heating arrangement may include:

> comparing the calculated rate of change of the resistance of the heating arrangement to a resistance rate of change increase threshold; and
> determining that a compromised condition criterion has been met if the calculated rate of change of resistance is positive and has a magnitude which is greater than the resistance rate of change increase threshold.

In addition or instead, analysing the calculated rate of change of the resistance of the heating arrangement to assess the condition of the heating arrangement may include:

comparing the calculated rate of change of the resistance of the heating arrangement to a resistance rate of change decrease threshold; and

determining that a compromised condition criterion has been met if the calculated rate of change of resistance is negative and has a magnitude which is greater than the resistance rate of change decrease threshold.

It may be that the method comprises:

determining a phase angle difference between the monitored current and the monitored voltage;

calculating the resistance of the heating arrangement based on the monitored current, the monitored voltage and the determined phase angle difference;

calculating a reactance of the heating arrangement based on the determined phase angle difference and the calculated resistance;

storing information relating to the calculated reactance of the heating arrangement; and

assessing the condition of the heating arrangement based on the stored information relating to the calculated reactance.

It may be that the heating arrangement comprises a plurality of heating components, each heating component being configured to receive a respective phase of a polyphase periodic AC electrical power supplied by a power supply, and the method comprises:

determining a phase angle difference between the monitored current and the monitored voltage for each heating component;

calculating a reactance of each heating component based on the monitored current, the monitored voltage and the determined phase angle difference;

calculating a reactance of each heating component based on the determined phase angle difference and the calculated resistance;

storing information relating to the calculated reactance of each heating component; and

assessing the condition of each heating component based on the stored information relating to the calculated reactance.

The heating arrangement may comprise a heating component which includes a heating element at least partially surrounded by an electrically insulating sheath, and assessing the condition of the heating arrangement based on the stored information relating to the calculated reactance may include: inferring a condition of the electrically insulating sheath based on the stored information relating to the calculated reactance.

Inferring the condition of the electrically insulating sheath based on the stored information relating to the calculated reactance may include: estimating a remaining service life of the heating arrangement based on the stored information relating to the calculated reactance.

Assessing the condition of the heating arrangement based on the stored information relating to the calculated reactance may include:

calculating a rate of change of the reactance of the heating arrangement based on the stored information relating to the calculated reactance; and

analysing the calculated rate of change of the reactance of the heating arrangement to assess the condition of the heating arrangement.

Assessing the condition of the heating arrangement based on the stored information relating to the calculated reactance may include:

comparing the calculated reactance of the heating arrangement to an upper reactance threshold; and

determining that a compromised condition criterion has been met if the calculated reactance is greater than the upper reactance threshold.

Additionally or alternatively, assessing the condition of the heating arrangement based on the stored information relating to the calculated reactance may include:

comparing the calculated reactance of the heating arrangement to a lower reactance threshold; and

determining that a compromised condition criterion has been met if the calculated reactance is less than the lower reactance threshold.

Analysing the calculated rate of change of the reactance of the heating arrangement to assess the condition of the heating arrangement may include:

comparing the calculated rate of change of the reactance of the heating arrangement to a reactance rate of change increase threshold; and
determining that a compromised condition criterion has been met if the calculated rate of change of reactance is positive and has a magnitude which is greater than the reactance rate of change increase threshold, and/or

In addition or instead, analysing the calculated rate of change of the reactance of the heating arrangement to assess the condition of the heating arrangement may include:

comparing the calculated rate of change of the reactance of the heating arrangement to a reactance rate of change decrease threshold; and
determining that a compromised condition criterion has been met if the calculated rate of change of reactance is negative and has a magnitude which is greater than the reactance rate of change decrease threshold.

It may be that condition of the heating arrangement is associated with: a structural integrity of the heating arrangement; a material degradation of the heating arrangement; and/or a material corrosion of the heating arrangement.

Further, it may be that assessing the condition of the heating arrangement includes determining whether a compromised condition criterion has been met and generating an alarm indicative of the heating arrangement being in a compromised condition in response to a determination that the compromised condition criterion has been met.

According to a third aspect there is provided a method of assessing a condition of a heating arrangement for heating a process medium, the method comprising:

monitoring a voltage supplied to the heating arrangement by a power supply using a voltage sensing arrangement;
monitoring a current drawn by the heating arrangement using a current sensing arrangement;
determining a phase angle difference between the monitored current and the monitored voltage;
storing information relating to the determined phase angle difference; and
assessing the condition of the heating arrangement based on the stored information relating to the determined phase angle difference.

It may be that the heating arrangement comprises a plurality of heating components, each heating component being configured to receive a respective phase of a polyphase periodic AC electrical power supplied by a power supply, and the method comprises:

determining a phase angle difference between the monitored current and the monitored voltage for each heating component;
storing information relating to the determined phase angle difference for each heating component; and
assessing the condition of each heating component based on the stored information relating to the determined phase angle difference.

The heating arrangement may comprise a heating component which includes a heating element at least partially surrounded by an electrically insulating sheath, and assessing the condition of the heating arrangement based on the stored information relating to the determined phase angle difference may include: inferring a condition of the electrically insulating sheath based on the stored information relating to the determined phase angle difference.

Inferring the condition of the electrically insulating sheath based on the stored information relating to the determined phase angle difference may include: estimating a remaining service life of the heating arrangement based on the stored information relating to the determined phase angle difference.

Assessing the condition of the heating arrangement based on the stored information relating to the determined phase angle difference may include:

calculating a rate of change of the phase angle difference; and
analysing the calculated rate of change of the phase angle difference to assess the condition of the heating arrangement.

Assessing the condition of the heating arrangement based on the stored information relating to the determined phase angle difference may include:

comparing the determined phase angle difference to an upper phase angle threshold; and
determining that a compromised condition criterion has been met if the determined phase angle difference is greater than the upper phase angle threshold, and/or

Additionally or alternatively, assessing the condition of the heating arrangement based on the stored information relating to the determined phase angle difference may include:

comparing the determined phase angle difference to a lower phase angle threshold; and
determining that a compromised condition criterion has been met if the determined phase angle difference is less than the lower phase angle threshold.

Analysing the calculated rate of change of the phase angle difference to assess the condition of the heating arrangement may include:

comparing the calculated rate of change of the phase angle difference to a phase angle rate of change increase threshold; and
determining that a compromised condition criterion has been met if the calculated rate of change of phase angle difference is positive and has a magnitude which is greater than the phase angle rate of change increase threshold.

In addition or instead, analysing the calculated rate of change of the reactance of the phase angle difference to assess the condition of the heating arrangement may include:

comparing the calculated rate of change of the reactance of the phase angle difference to a phase angle rate of change decrease threshold; and
determining that a compromised condition criterion has been met if the calculated rate of change of phase angle difference is negative and has a magnitude which is greater than the phase angle rate of change decrease threshold.

It may be that the condition of the heating arrangement is associated with: a structural integrity of the heating arrangement; a material degradation of the heating arrangement; and/or a material corrosion of the heating arrangement.

Further, it may be that assessing the condition of the heating arrangement includes determining whether a compromised condition criterion has been met and generating an alarm indicative of the heating arrangement being in a compromised condition in response to a determination that the compromised condition criterion has been met.

According to a fourth aspect there is provided a system comprising:

a heating arrangement for heating a process medium;
a voltage sensing arrangement;
a current sensing arrangement; and
a data processing apparatus configured to assess a condition of the heating arrangement in accordance with the method of any of the first aspect, the second aspect or the third aspect.

According to a fifth aspect there is provided a machine-readable storage medium having stored thereon instructions which, when executed by a data processing apparatus, cause the data processing apparatus to carry out the method of any of the first aspect, the second aspect or the third aspect.

BRIEF DESCRIPTION OF THE DRAWINGS

FIG. 1 shows, schematically, a first example system;
FIG. 2 shows, schematically, a second example system;
FIG. 3 shows, schematically, a third example system;
FIG. 4 shows a detail sectional view of a heating component in a first condition;
FIG. 5 shows a detail sectional view of a heating component in a second condition;
FIG. 6 is a flowchart which shows a first example method of controlling a system;
FIG. 7 is a flowchart showing an example resistance-based assessment action of the method shown in FIG. 6 in detail;
FIG. 8 is a flowchart showing an example reactance-based assessment action of the method shown in FIG. 6 in detail;
FIG. 9 is a flowchart showing an example first resistance-based evaluation as shown in

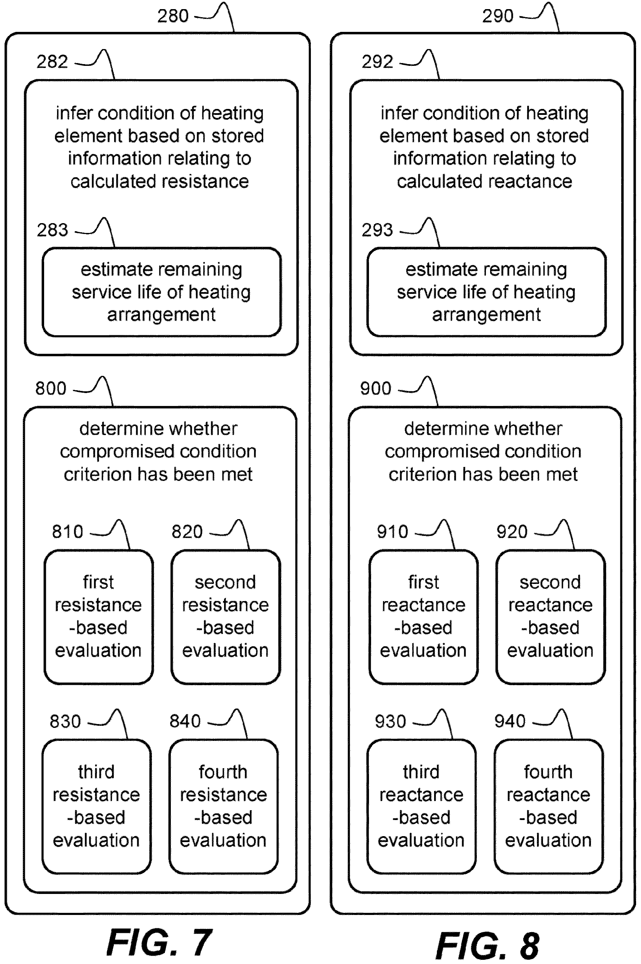

FIG. 7 in detail;

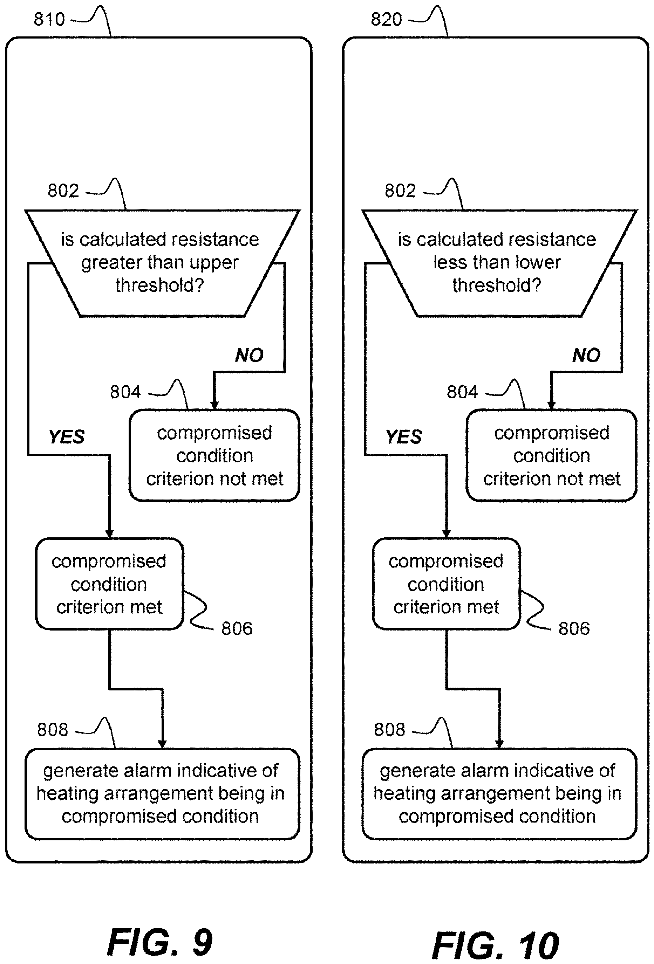

FIG. 10 is a flowchart showing an example second resistance-based evaluation as shown in FIG. 7 in detail;

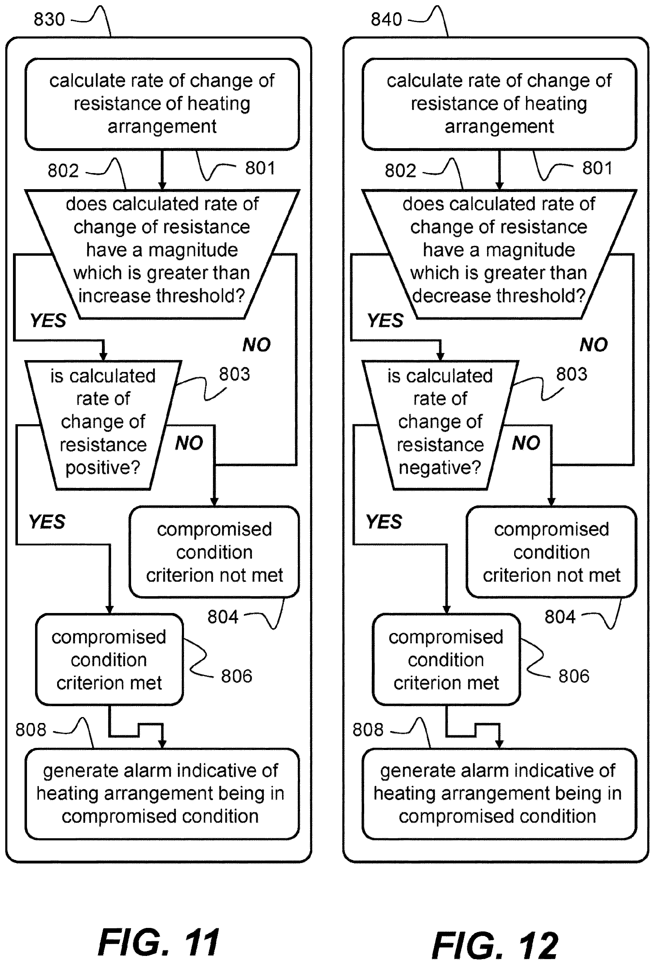

FIG. 11 is a flowchart showing an example third resistance-based evaluation as shown in FIG. 7 in detail;
FIG. 12 is a flowchart showing an example fourth resistance-based evaluation as shown in FIG. 7 in detail;

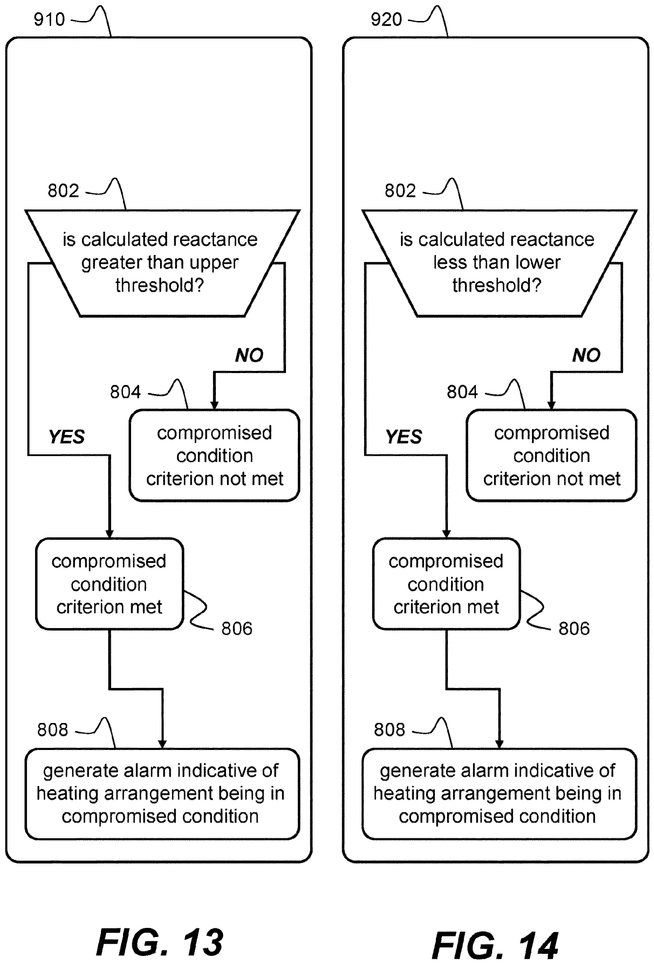

FIG. 13 is a flowchart showing an example first reactance-based evaluation as shown in FIG. 8 in detail;
FIG. 14 is a flowchart showing an example second reactance-based evaluation as shown in FIG. 8 in detail;

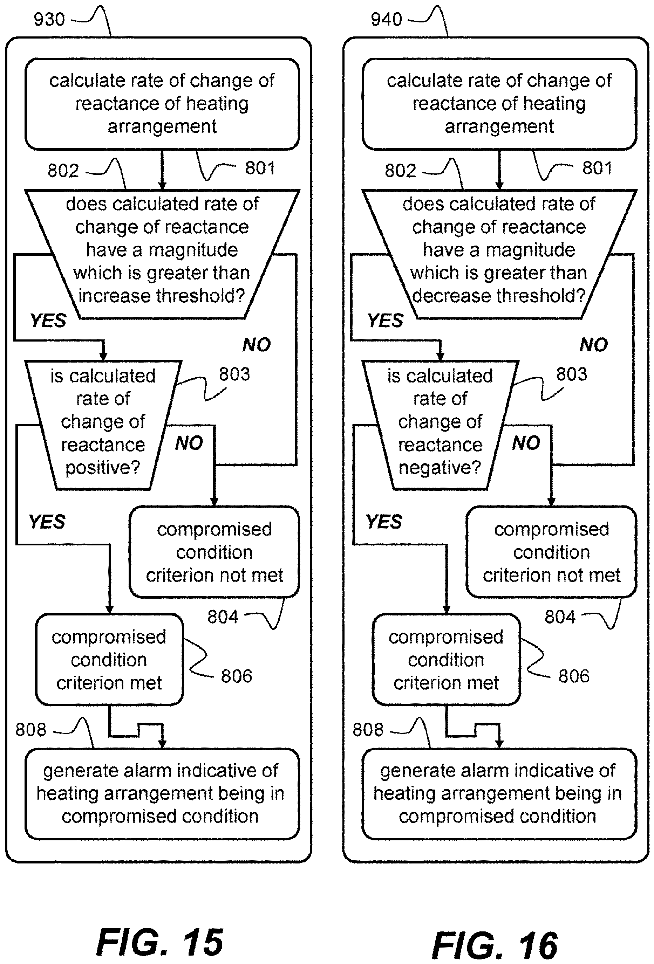

FIG. 15 is a flowchart showing an example third reactance-based evaluation as shown in FIG. 8 in detail;
FIG. 16 is a flowchart showing an example fourth reactance-based evaluation as shown in FIG. 8 in detail;

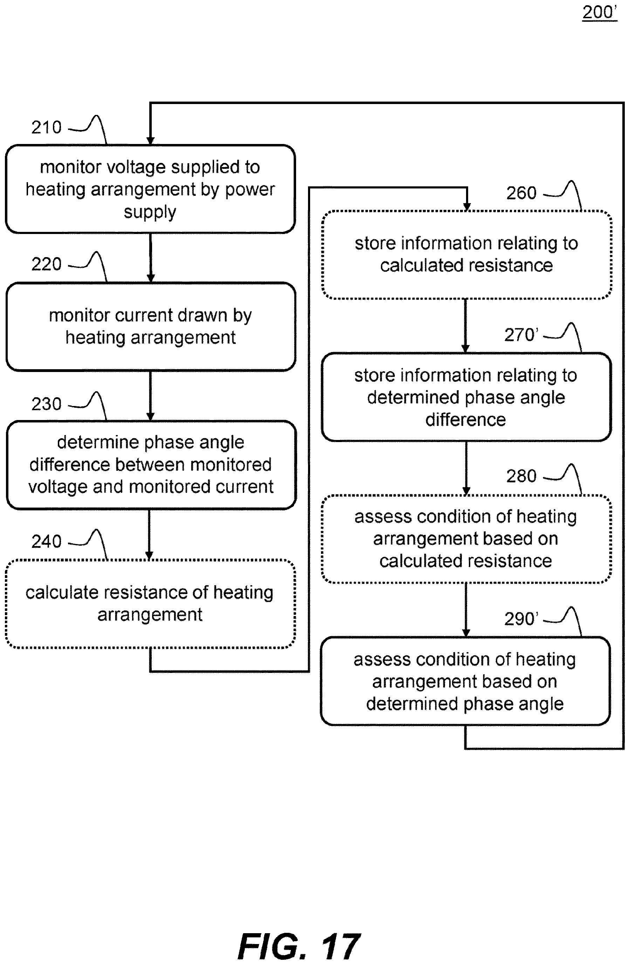

FIG. 17 is a flowchart which shows a second example method of controlling a system;

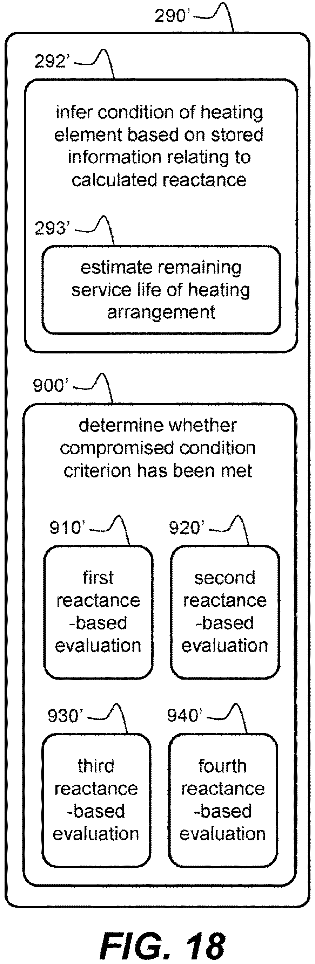

FIG. 18 is a flowchart showing an example phase angle-based assessment action of the method shown in FIG. 17 in detail;

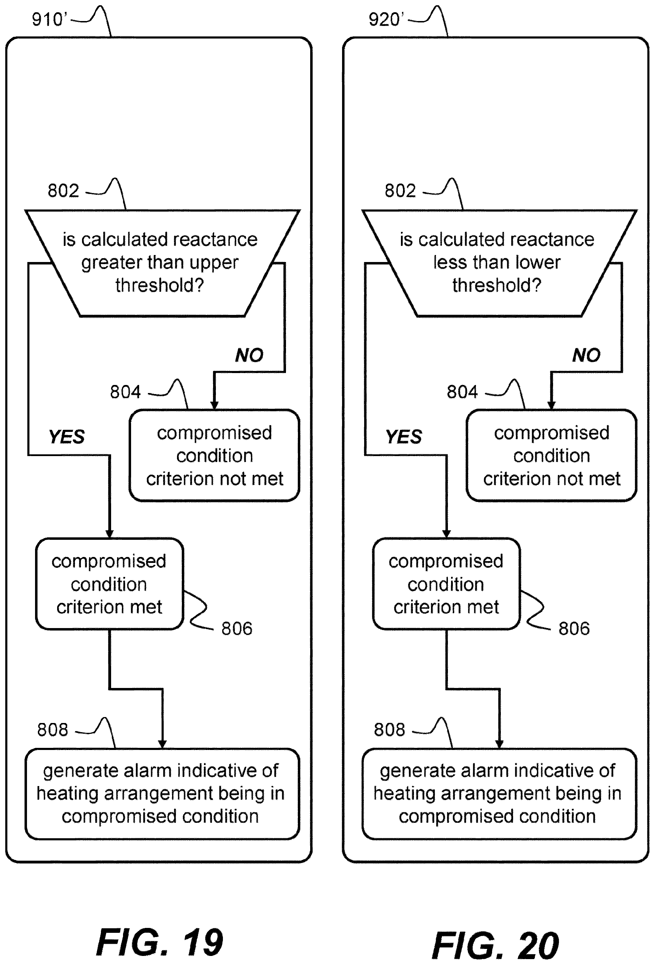

FIG. 19 is a flowchart showing an example first phase angle-based evaluation as shown in FIG. 18 in detail;
FIG. 20 is a flowchart showing an example second phase angle-based evaluation as shown in FIG. 18 in detail;

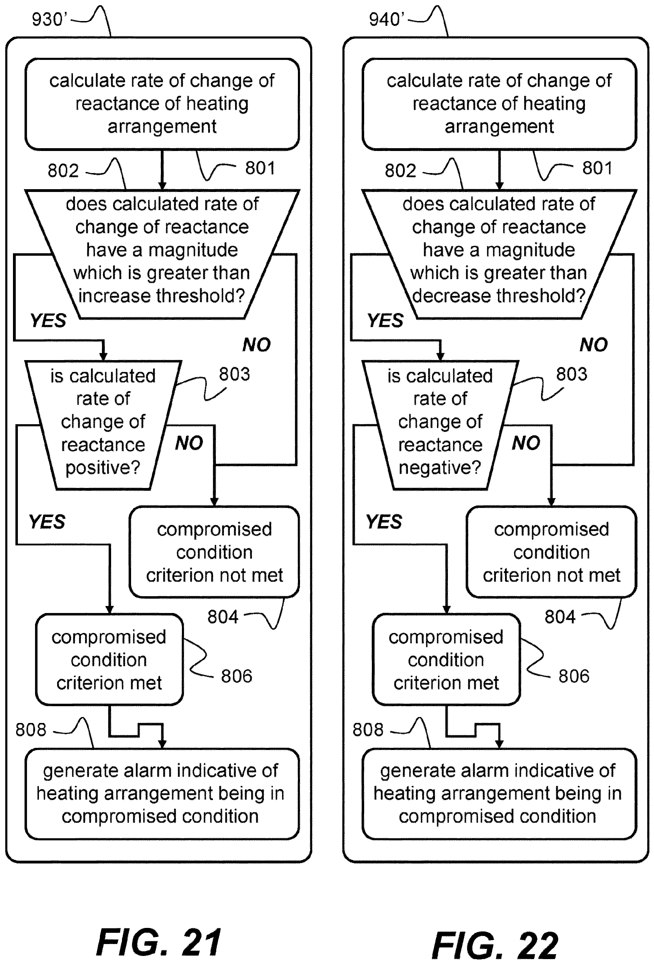

FIG. 21 is a flowchart showing an example third phase angle-based evaluation as shown in FIG. 18 in detail;
FIG. 22 is a flowchart showing an example fourth phase angle-based evaluation as shown in FIG. 18 in detail;

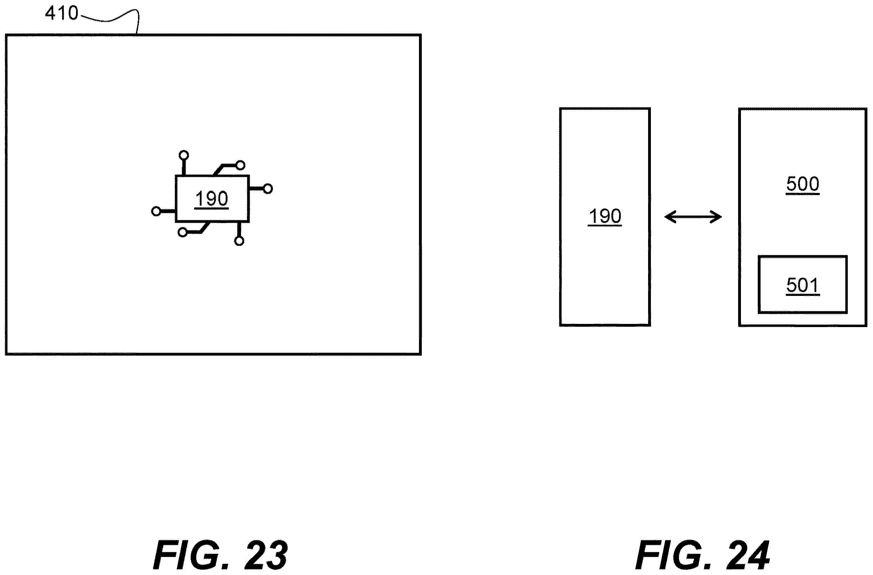

FIG. 23 is a highly schematic diagram of a data processing apparatus comprising a controller; and

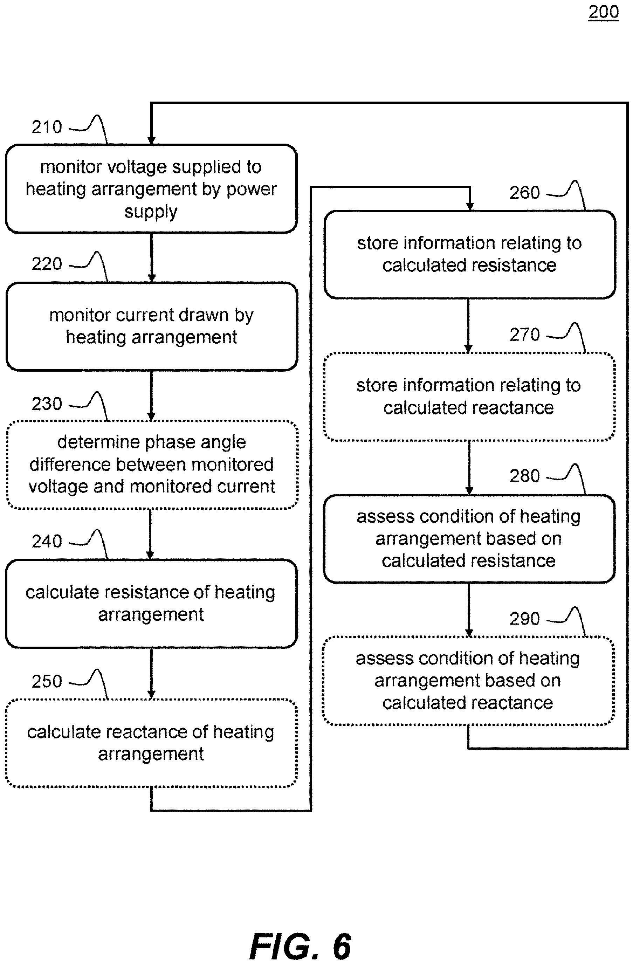

FIG. 24 shows, symbolically, a machine-readable medium having stored thereon a computer program which, when executed by a data processing apparatus, causes the data processing apparatus to perform the method of FIG. 6 or FIG. 17.

## DETAILED DESCRIPTION

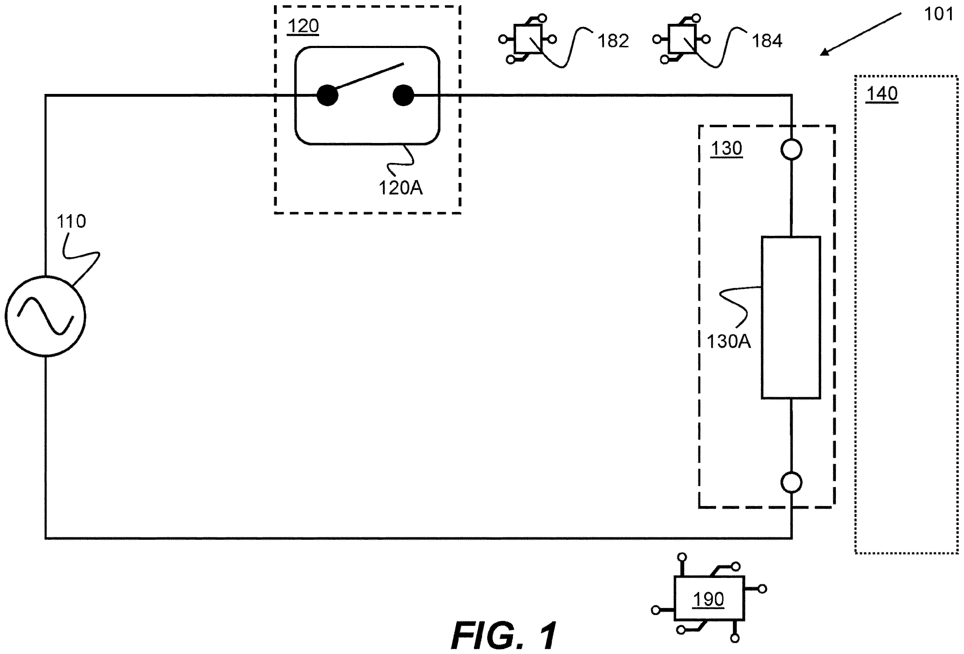

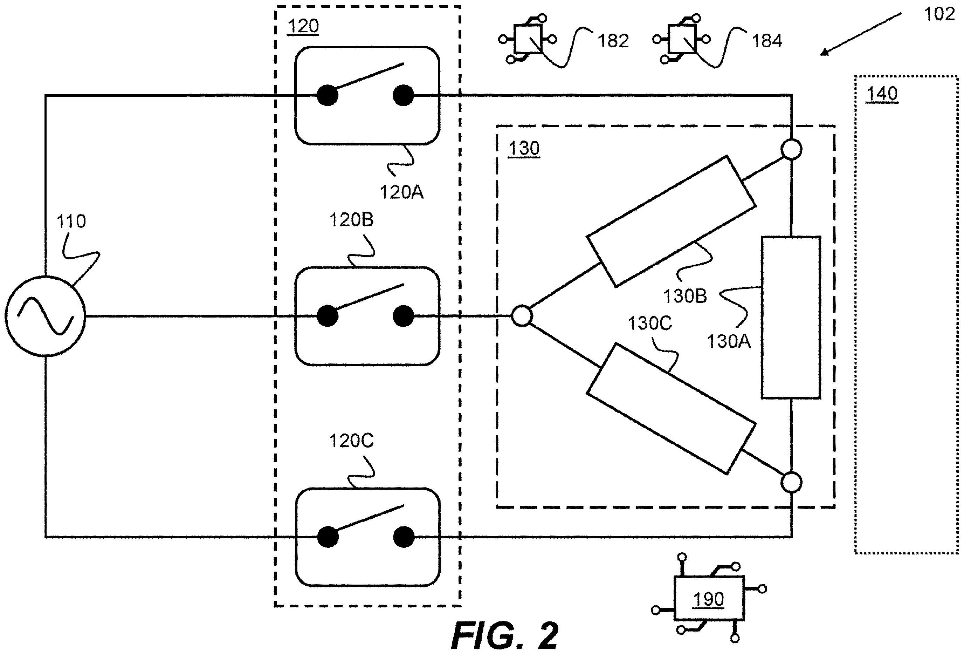

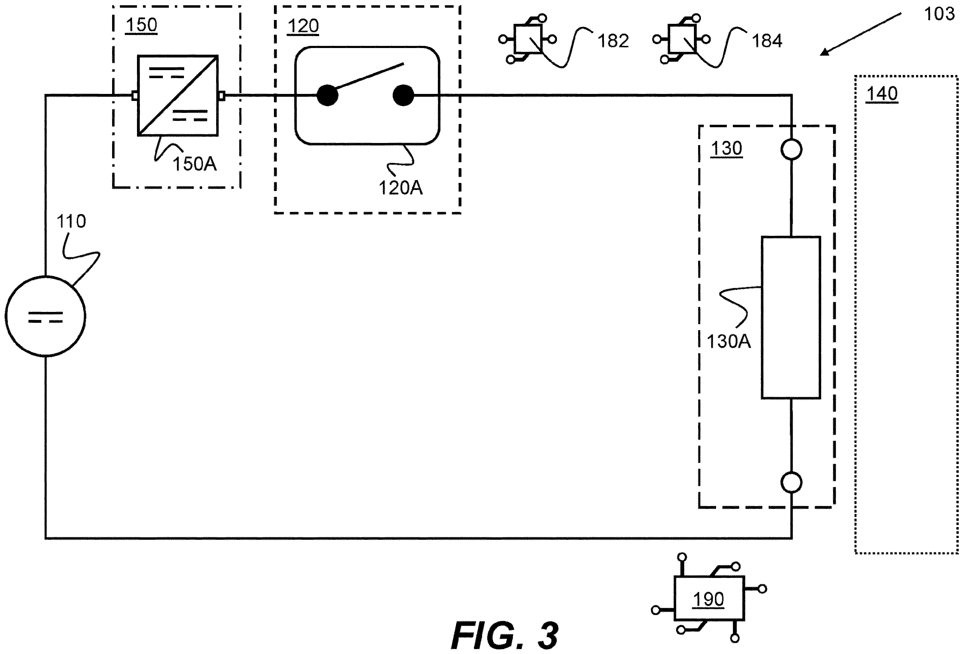

**FIG. 1** shows a first example system 101 comprising a switching arrangement 120, a heating arrangement 130 for heating a process medium 140, a voltage sensing arrangement 182, a current sensing arrangement 184 and a controller 190. **FIG. 2** shows a second example system 102 which is generally similar to the first example system 101, with like reference signs indicating common or similar features. **FIG. 3** shows a third example system 103 which is generally similar to the first example system 101, with like reference signs indicating common or similar features. The differences between each of the first example system 101, the second example system 102 and the third example system 103 are explained in detail below.

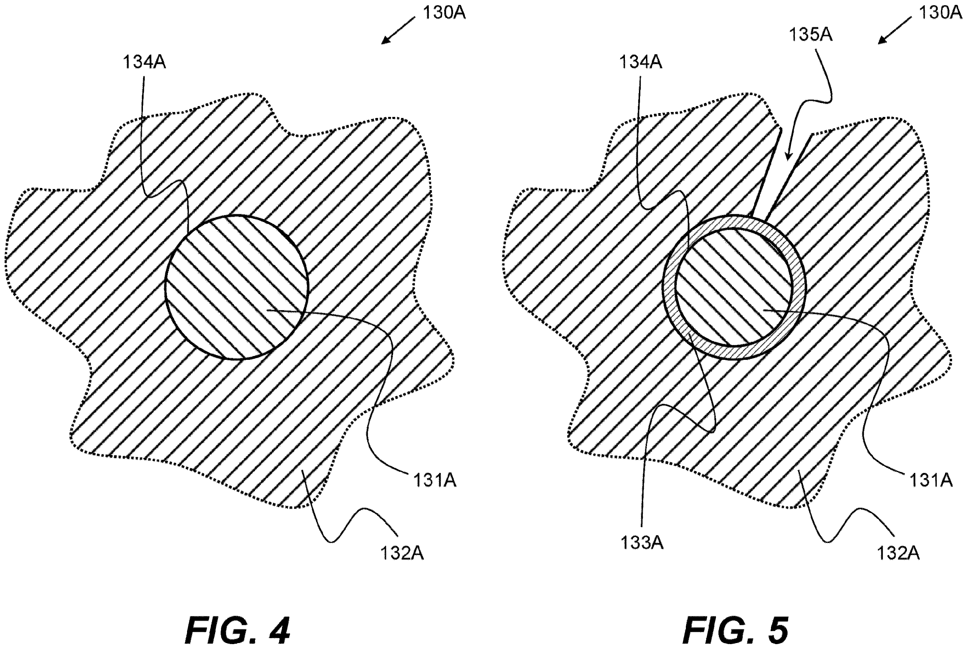

The switching arrangement 120 is generally configured to selectively couple a power supply 110 to the heating arrangement 130. When the power supply 110 is coupled to the heating arrangement 130 by the switching arrangement 120, the power supply 110 provides electrical power to the heating arrangement 130 for heating the process medium 140. The heating arrangement 130 is configured to convert electrical power supplied from the power supply 110 via the switching arrangement 120 into heat by means of an Ohmic heating process within a heating element of the heating arrangement 130. Heat is then transferred to the process medium 140 as a result of conduction, convection and/or radiation, as will be appreciated by those skilled in the art. For this purpose, the heating arrangement 130 comprises at least one heating component 130A-130C. The at least one heating component 130A-130C includes a heating element which may be at least partially surrounded by an electrically insulating sheath, as described in further detail with respect to FIGs 4 and 5 below. When the power supply 110 is decoupled from (e.g. isolated from) the heating arrangement 130 by the switching arrangement 120, the power supply 110 does not provide electrical power to the heating arrangement 130.

To selectively couple the power supply 110 to the heating arrangement 130, the switching arrangement 120 optionally comprises at least one semiconductor switch. In use, the heating arrangement 130 may generally require the supply of a relatively large electric current to adequately heat the process medium 130. Consequently, other example systems in accordance with the present disclosure may make use of non-semiconductor switches for the purpose of selectively coupling and/or decoupling a power supply to a heating arrangement. For example, the switching arrangement 120 optionally comprises at least one mechanical or non-semiconductor switch 120A (e.g. at least one contactor 120A). It will be understood that mechanical or other non-semiconductor switches may generally have a higher rated current than semiconductor switches. However, use of at least one semiconductor switch 120A within the switching arrangement 120 advantageously enables selective coupling and/or decoupling of the power supply 110 and the heating arrangement 130 to be executed more rapidly compared to mechanical or non-semiconductor switches.

To this end, the at least one semiconductor switch 120A-120C may be, for example, a transistor or a thyristor. In particular, the or each semiconductor switch may be a field-effect transistor, a gate turn-off thyristor, integrated-gate bipolar transistor, an integrated gate-commutated thyristor, and/or an injection-enhanced gate transistor. Use of such types of semiconductor switches as a part of the switching arrangement 120 may provide more robust means (compared to a mechanical or non-semiconductor switch) for selectively coupling and/or decoupling the power supply 110 from the heating arrangement 130, which is associated with an extended lifetime of the system 101, 102, 103.

In both the first example electrical system 101 and the second example electrical system 102, the power supply 110 is an alternating current (AC) power supply 110. Accordingly, when the power supply 110 is coupled to the heating arrangement 130 by the switching arrangement 120, the power supply 110 provides a periodic AC electrical power to the heating arrangement 130.

In the first example electrical system 101 shown in FIG. 1, the power supply 110 is a monophase AC power supply 110. Therefore, when the power supply 110 is coupled to the heating arrangement 130 by the switching arrangement 120, the power supply 110 provides a monophase periodic AC electrical power to the heating arrangement 130. The switching arrangement 120 comprises a single semiconductor switch 120A, while the heating arrangement 130 comprises a single heating component 130A.

In the second example electrical system 102 shown in FIG. 2, the power supply 110 is a polyphase AC power supply 110. Therefore, when the power supply 110 is coupled to the heating arrangement 130 by the switching arrangement 120, the power supply 110 provides a polyphase periodic AC electrical power to the heating arrangement 130. The switching arrangement 120 comprises a plurality of semiconductor switches 120A-120C. The heating arrangement 130 comprises a plurality of heating components 130A-130C. Although the power supply 110 is shown as being a three-phase AC power supply in the example of FIG. 2, those skilled in the art will appreciate that the principles described herein apply to similar systems provided with polyphase AC power supplies having any suitable number of phases. In the specific example of FIG. 2, the plurality of semiconductor switches includes a first semiconductor switch 120A, a second semiconductor swich 120B, and a third semiconductor switch 120C. Further, the plurality of heating components 130A-130C includes a first heating component 130A, a second heating component 130B, and a third heating component 130C. Each heating component 130A-130C is configured to receive a respective phase of the polyphase electrical power provided by the power supply 110 via a corresponding semiconductor switch 120A-120C of the switching arrangement 120. Each phase of the polyphase electrical power is different to each other phase of the polyphase electrical power (that is, each phase of the polyphase electrical power has a different phase angle relative to each other phase of the polyphase electrical power). The supply of a respective phase of a polyphase electrical power to the heating arrangement 130 enables a smoother transfer of heat from the heating arrangement 130 to the process medium 140, because there is never any point in time, in use, when the applied voltage or the applied current within the heating arrangement 130 is zero.

In the third example electrical system 102 shown in FIG. 3, the power supply 110 is a direct current (DC) power supply 110. It follows that, when the power supply 110 is coupled to the heating arrangement 130 by the switching arrangement 120, the power supply 110 provides a DC electrical power to the heating arrangement 130. Additionally, the third example system 103 optionally comprises a DC-DC converter 150 configured to convert a DC electric current received from the power supply 110 having a first current magnitude into a DC electric current having a second current magnitude for supply to the heating arrangement 130 via the switching arrangement 120. The first current magnitude may generally be dissimilar to (i.e. different from) the second current magnitude. Accordingly, the DC-DC converter 150 is operable to control the magnitude of the DC electric current supplied to the heating arrangement 130 when the heating arrangement 130 is coupled to the power supply 110 by the switching arrangement 120. For this purpose, the DC-DC converter 150 may comprise a chopper converter 150A. This may ensure particularly efficient and effective conversion of the DC currents received from the power supply 110 and provided to the heating arrangement 130, respectively, by the DC-DC converter 150. The chopper converter 150A may be a step-up chopper or a step-down chopper converter.

In each of the example systems 101, 102, 103, the voltage sensing arrangement 182 is adapted to monitor a voltage supplied to the heating arrangement 130 by the power supply 110. Further, in each of the example systems 101, 102, 103, the current sensing arrangement 184 is adapted to monitor an electrical current drawn by the heating arrangement 130. Specific types of voltage monitoring circuitry/apparatus suitable for use within the voltage sensing arrangement 182 for the purpose of monitoring the voltage supplied to the heating arrangement 130 by the power supply 110 and/or specific types of current monitoring circuitry/apparatus suitable for use within the current sensing arrangement 184 for the purpose of monitoring electrical current drawn by the heating arrangement 130 will be known to those skilled in the art. For example, suitable voltage monitoring apparatus for the voltage sensing arrangement 182 may include a voltage transformer, a resistive or capacitive divider (with suitable detection circuitry), an electrostatic force detector, a voltage transducer or the like.

In each of the example systems 101, 102, 103, the controller 190 may be in data communication with the voltage sensing arrangement 182 and/or current sensing arrangement 184 by means of a wired and/or a wireless data connection. The controller 190 is also configured to control the switching arrangement 120 in each of the example systems 101, 102, 103. In the third example system 103, the controller 190 is further configured to control the DC-DC converter 150 (if provided). The controller 190 is configured to control the system 101, 102, 103 in accordance with the example method described below with reference to FIG. 6.

**FIGs. 4-5** show detailed sectional views of part of a heating component 130A for use as a heating component 130A in the systems 101, 103 described above with reference to FIGs. 1 or 3, or as a heating component 130A - 130C in the system 102 described above with reference to FIG. 2. The heating component 130A comprises a heating element 131A which is surrounded by an electrically insulating sheath 132A. As will be appreciated by those skilled in the art, the electrically insulating sheath 132A is generally configured to insulate the heating element 131A from the process medium 140 and other components/media external to the heating arrangement 130. To this end, the electrically insulating sheath 132A may generally be formed from a material having a low electrical conductivity (e.g. a material having an electrical resistivity equal to or greater than $1 \times 10^{10}$ Ω m). Optionally, the electrically insulating sheath 132A may be formed from a material comprising glass, porcelain, or a composite polymer. In addition, the electrically insulating sheath may have a relatively high dielectric strength to mitigate a risk of a dielectric breakdown (also referred to an electrical breakdown) due to a voltage difference between the heating element 131A and the process medium 140 and/or a voltage difference between the heating element 131A of the heating component 130A and respective heating elements 131B-131C of any other heating components 130B-130C of the heating arrangement 130 (as in the system 102 of FIG. 2).

As used herein, the term "condition" of the heating arrangement 130 (i.e. a condition of the or each heating component 130A-130C of the heating arrangement 130) may be associated with and used to refer to: a structural integrity of the heating arrangement 130, a material degradation of the heating arrangement 130, and/or a material corrosion of the heating arrangement 130. The condition of the heating arrangement 130 is therefore related to a heating performance of the heating arrangement 130 and/or a safety of the heating arrangement 130.

In FIG. 4, the heating component 130A is in a first condition. In the first condition, the electrically insulating sheath 132A is substantially continuous and intact (e.g. free of cracks or other structural flaws). Further, the heating element 131A is substantially materially pure (e.g. not corroded). As a result of being in the first condition, the heating performance of the heating component 130A is relatively high and/or the safety of the heating component 130A is relatively good. The heating component 130A may generally be in the first condition shortly after manufacturing and installation within the system 101, 102, 103.

In contrast, the heating component 130A is in a second condition in FIG. 5. In the second condition, the electrically insulating sheath 132A includes a crack 135A which extends to a surface 134A of the heating element 131A. Therefore, the insulating sheath 132A may be described as lacking structural integrity (e.g. structurally flawed). Therefore, an ability of the insulating sheath 132A to insulate the heating element 131A from the process medium 140 and other components/media is reduced. In addition, a layer of oxidised material 133A is present on the surface 134A of the heating element 131A. Accordingly, the heating element 131A may be described as being materially corroded and/or materially degraded. As a consequence of being in the second condition, the heating performance of the heating component 130A is relatively low and/or the safety of the heating component 130A is relatively poor (compared to the heating performance and/or safety when the heating component is in the first condition). The heating component 130A may generally be in the second condition after extended use, e.g. over a period of months or years.

In the discussion of FIGs. 4 and 5 above, the heating element 131A is described as being surrounded by an electrically insulating sheath 132A. However, this disclosure envisages that the or each heating element 131A may be only partially surrounded by an electrically insulating sheath 132A. Further, if the heating arrangement 130 comprises a plurality of heating components 130A-130C as described above in respect of FIG. 2, each of the plurality of heating components 130A-130C may comprise a heating element 131A which is at least partially surrounded by an electrically insulating sheath 132A. If so, it may be that each of the plurality of heating elements 131A is at least partially surrounded by a respective electrically insulating sheath 132A or it may be that a common electrically insulating sheath 132A at least partially surrounds more than one of the plurality of heating elements 131A.

**FIG. 6** is a flowchart which shows a first example method 200 of assessing a condition of a heating arrangement for heating a process medium, wherein the heating arrangement forms part of a system in accordance with any of the example systems 101, 102, 103 described above with reference to FIGs. 1-5.

The method 200 includes an action of monitoring (at block 210) a voltage $V_{130}$ supplied to the heating arrangement 130 by the power supply 110 using the voltage sensing arrangement 182. If the power supply 110 is a polyphase AC power supply 110 as in the system 102 of FIG. 2, the action of monitoring (at block 210) the voltage supplied to the heating arrangement 130 by the power supply 110 using the voltage sensing arrangement 182 may include monitoring the voltage $V_{130A}$, $V_{130B}$, $V_{130C}$ supplied to each heating component 130A-130C of the heating arrangement 130 by the power supply 110 using the voltage sensing arrangement 182.

The method 200 further comprises an action of monitoring (at block 220) a current $I_{130}$ drawn by the heating arrangement 130 (i.e. the current drawn from the power supply 110) using the current sensing arrangement 184. If the power supply 110 is a polyphase AC power supply 110 as in the system 102 of FIG. 2, the action of monitoring (at block 220) the current drawn by the heating arrangement 130 using the current sensing arrangement 184 may include monitoring a current $I_{130A}$, $I_{130B}$, $I_{130C}$ drawn by each heating component 130A-130C of the heating arrangement 130 using the current sensing arrangement 184.

If the power supply 110 is an AC power supply 110 as in the example systems 101, 102 described above with respect to FIGs. 1 and 2, the method 200 also includes an action of determining (at block 230) a phase angle difference $\theta_{130}$ between the monitored voltage (as monitored at block 210) and the monitored current (as monitored at block 220). If the power supply 110 is a polyphase AC power supply 110 as in the system of FIG. 3, the action of determining (at block 230) the phase angle difference $\theta_{130}$ between the monitored voltage (as monitored at block 210) and the monitored current (as monitored at block 220) may include determining a phase angle difference $\theta_{130A}$, $\theta_{130B}$, $\theta_{130C}$ between the monitored voltage (as monitored at block 210) and the monitored current (as monitored at block 220) for each heating component 130A-130C. However, if the power supply 110 is a DC power supply 110 as in the example system 103 described above with respect to FIG. 3, the method 200 does not include any action of determining a phase angle difference between the monitored voltage and the monitored current because no such phase angle difference exists.

In either case, the method 200 further comprises an action of calculating (at block 240) a resistance $R_{130}$ of the heating arrangement 130 based on the monitored voltage (as monitored at block 210) and the monitored current (as monitored at block 220). If the power supply 110 provides a periodic AC electrical power to the heating arrangement 130, the action of calculating (at block 240) the $R_{130}$ resistance of the heating arrangement 130 is based on the monitored voltage (as monitored at block 210), the monitored current as monitored at block 220 as well as the determined phase angle difference, $\theta$, (as determined at block 230). If the power supply 110 is a polyphase AC power supply 110 as in the system of FIG. 3, the action of calculating (at block 240) the resistance $R_{130}$ of the heating arrangement 130 may include calculating a resistance $R_{130A}$, $R_{130B}$, $R_{130C}$ of each heating component 130A-130C.

Specifically, if the power supply 110 is a DC power supply 110, the resistance $R_{130}$ of the heating arrangement 130 may be calculated according to Ohm's law as:

$$R_{130} = V_{130}/I_{130} \tag{1}$$

On the other hand, if the power supply 110 is an AC power supply 110, the resistance $R_{130}$ of the heating arrangement 130 may be calculated as:

$$R_{130} = Z_{130}\cos(\theta_{130}) = V_{130}\cos(\theta_{130})/I_{130} \tag{2}$$

where $Z_{130}$ is the impedance of the heating arrangement 130.

Moreover, if the power supply 110 is a polyphase AC power supply 110 as described above with reference to FIG. 2, the resistance $R_{130A}$, $R_{130B}$, $R_{130C}$ of each heating component 130A-130C may be calculated according to the following set of equations:

$$\begin{aligned} R_{130A} &= V_{130A}\cos(\theta_{130A})/I_{130A} \\ R_{130B} &= V_{130B}\cos(\theta_{130B})/I_{130B} \\ R_{130C} &= V_{130C}\cos(\theta_{130C})/I_{130C} \end{aligned} \tag{3}$$

Further, if the power supply 110 is an AC power supply 110 as in the example systems 101, 102 of FIGs. 1 and 2, the method 200 also includes an action of calculating (at block 250) a reactance $X_{130}$ of the heating arrangement 130 based on the determined phase angle difference (as determined at block 230) and the calculated resistance (as calculated at block 240).

If the power supply 110 is a polyphase AC power supply 110 as in the system of FIG. 2, the action of calculating (at block 250) the reactance $X_{130}$ of the heating arrangement 130 may include calculating a reactance $X_{130A}$, $X_{130B}$, $X_{130C}$ of each heating component 130A-130C.

Specifically, the reactance $X_{130}$ of the heating arrangement may be calculated as follows:

$$X_{130} = \left[Z_{130}^2 - R_{130}^2\right]^{.5} = \left[\left(\frac{R_{130}}{\cos(\theta_{130})}\right)^2 - R_{130}^2\right]^{.5} = R_{130} \times \sqrt[2]{(\sec(\theta_{130}))^2 - 1} \tag{4}$$

In addition, if the power supply 110 is a polyphase AC power supply 110 as described above with reference to FIG. 2, the reactance $X_{130A}$, $X_{130B}$, $X_{130C}$ of each heating component 130A-130C may therefore be calculated using the following set of equations:

$$\begin{aligned} X_{130A} &= R_{130A} \times \sqrt[2]{(\sec(\theta_{130A}))^2 - 1} \\ X_{130B} &= R_{130B} \times \sqrt[2]{(\sec(\theta_{130B}))^2 - 1} \\ X_{130C} &= R_{130C} \times \sqrt[2]{(\sec(\theta_{130C}))^2 - 1} \end{aligned} \tag{5}$$

In addition, the method 200 includes an action of storing (at block 260) information relating to the calculated resistance (as calculated at block 240). The information relating to the calculated resistance includes at least a value of the calculated resistance, and may also include associated information such as a time at which the resistance was calculated.

Similarly, if the method 200 includes the action of calculating (at block 250) the reactance $X_{130}$ of the heating arrangement 130, the method 200 also includes an action of storing (at block 270) information relating to the calculated reactance (as calculated at block 250). The information relating to the calculated reactance includes at least a value of the calculated reactance, and may also include associated information such as a time at which the reactance was calculated.

The information relating to the calculated resistance and optionally the information relating to the calculated reactance may be stored (at block 260 or block 270) within a volatile or non-volatile local memory of the system 101, 102, 103, such as a memory of the controller 190 described above. Additionally or alternatively, the information relating to the calculated resistance and optionally the information relating to the calculated reactance may be stored within a volatile or non-volatile remote memory (that is, remote to the system 101, 102, 203), such as a memory of an external system (e.g. a remote server or a remote computational device) from which the information may be subsequently accessed by an external data processing apparatus via a wired or wireless connection.

The method 200 also includes an action of assessing (at block 280) the condition of the heating arrangement 130 based on the calculated resistance (as calculated at block 260). The action represented by block 280 is referred to as a resistance-based assessment action herein. Likewise, if the method 200 includes the actions represented by each of blocks 230, 250, and 270, the method 200 may further comprise an action of assessing (at block 290) the condition of the heating arrangement 130 based on the calculated reactance (as calculated at block 270). The action represented by block 290 is referred to as a reactance-based assessment action herein.

FIG. 7 is a flowchart which shows an example resistance-based assessment action (in block 280) of the method 200 shown by FIG. 6 in detail. In the example of FIG. 7, the resistance-based assessment action (in block 280) comprises: a first resistance-based assessment process (at block 282) and a second resistance-based assessment process (at block 800). **FIG. 8** is a flowchart which shows an example reactance-based assessment action (in block 290) of the method 200 shown by FIG. 6 in detail. In a similar way to the resistance-based assessment action (in block 280), the reactance-based assessment action (in block 290) comprises: a first reactance-based assessment process (at block 292) and a second reactance-based assessment process (at block 900).

As described in further detail below, any of the resistance-based assessment processes represented by blocks 282 and 800 may include a step of calculating a rate of change of the resistance of the heating arrangement 130 based on the stored information relating to the calculated resistance (as stored at block 260, see FIG. 6). Similarly, any of the reactance-based assessment processes represented by blocks 292 and 900 may include a step of calculating a rate of change of the reactance of the heating arrangement 130 based on the stored information relating to the calculated reactance (as stored at block 270, see FIG. 6). The calculated rate of change of the resistance of the heating arrangement 130 may then be used to assess the condition of the heating arrangement 130, as described in further detail with reference to the first resistance-based assessment process and the second resistance-based assessment process (at blocks 282 and 800, respectively). In a corresponding manner, the calculated rate of change of the reactance of the heating arrangement 130 may then be used to assess the condition of the heating arrangement 130, as described in further detail with reference to the first reactance-based assessment process and the second reactance-based assessment process (at blocks 292 and 900, respectively).

The resistance of the heating arrangement 130 may be considered as being generally indicative of a condition of the or each heating element 131A (as opposed to being generally indicative of a condition of the or each insulating sheath 132A). Conversely, the reactance of the heating arrangement 130 may be considered as being generally indicative of the condition of the or each electrically insulating sheath 132A (as opposed to being generally indicative of the condition of the or each heating element 131A).

The first resistance-based assessment process (at block 282) includes inferring the condition of the or each heating element 131A based on the stored information relating to the calculated resistance (at block 260, see FIG. 6). Inferring the condition of the or each heating element 131A may be based on the calculated resistance itself and/or a calculated rate of change or resistance as discussed above. For example, the calculated resistance and/or the calculated rate of change of resistance may be generally indicative of the or each heating element 131A being significantly materially corroded and/or significantly materially degraded (as described with respect to FIG. 5 above).

Correspondingly, the first reactance-based assessment action (at block 292) includes inferring the condition of the or each electrically insulating sheath 132A based on the stored information relating to the calculated reactance (at block 270, see FIG. 6). Inferring the condition of the or each electrically insulating sheath 132A may be based on the calculated reactance itself and/or a calculated rate of change of reactance as discussed above. For example, the calculated reactance and/or the calculated rate of change of reactance may be generally indicative of the or each electrically insulating sheath 132A being structurally flawed and/or lacking structural integrity (as described with respect to FIG. 5 above).

The inferred condition of the or each heating element 131A and/or the or each electrically insulating sheath 132A may be used as a basis for carrying out appropriate maintenance to and/or scheduling timely replacement of the heating arrangement 130 (or the or each heating element 131A or the or each electrically insulating sheath 132A alone).

Inferring the condition of the or each heating element 131A and/or the or each electrically insulating sheath 132A may by reference to a model (e.g. a physics-based model or a statistically-based model). The model may correlate the stored information relating to the calculated resistance to the condition of the or each heating element 131A. The same model or a separate model may correlate the stored information relating to the calculated reactance to the condition of the or each electrically insulating sheath 132A. The or each model may be a data-driven "black box" model of the condition of the heating arrangement 130 and the stored information relating to the calculated resistance and/or, optionally, the calculated reactance, such as a neural network model. Further, the or each model may comprise a look-up table correlating the storing information relating to the calculated resistance to the condition of the or each heating element 131A and/or, optionally, correlating the stored information relating to the calculated reactance to the condition of the or each electrically insulating sheath 132A.

In particular, the or each model may be used to estimate (at block 283 and/or, optionally, at block 293) a remaining service life of the heating arrangement 130. An age (e.g. a current service age, expressed in units of time) of the heating arrangement 130 may be used by the model in conjunction with the stored information relating to calculated resistance and/or, optionally, in conjunction with the stored information relating to the calculated reactance to estimate the remaining service life of the heating arrangement 130. The estimated remaining service life of the heating arrangement 130 may be displayed on a human-machine interface to the system 101, 102, 103 and/or transmitted to an external system (e.g. a remote server or a remote computational device) from which the information may be subsequently accessed by an external data processing apparatus via a wired or wireless connection.

The estimated remaining service life may be used as a specific basis for scheduling timely replacement of the heating arrangement 130 (or the or each heating element 131A or the or each electrically insulating sheath 132A alone).

In general terms, the second resistance-based assessment process (represented by block 800) includes determining whether a compromised condition criterion has been met based on the stored information relating to the calculated resistance (at block 260, see FIG. 6) and generating an alarm indicative of the heating arrangement 130 being in a compromised condition in response to a determination that the compromised condition criterion has been met, as explained in further detail below with reference to FIGs. 9-12. To this end, the second resistance-based assessment process (as represented by block 800) includes one or more resistance-based evaluations. In the example of FIG. 7, the second resistance-based assessment process includes: a first resistance-based evaluation (at block 810), a second resistance-based evaluation (at block 820), a third resistance-based evaluation (at block 830), and a fourth resistance-based evaluation (at block 840).

Likewise, the second reactance-based assessment process (represented by block 900) generally includes determining whether a compromised condition criterion has been met based on the stored information relating to the calculated reactance (at block 270, see FIG. 6) and generating an alarm indicative of the heating arrangement 130 being in a compromised condition in response to a determination that the compromised condition criterion has been met, as explained in further detail below with reference to FIGs. 13-16. For this purpose, the second reactance-based assessment process (as represented by block 900) includes one or more reactance-based evaluations. In the example of FIG. 8, the second reactance-based assessment process includes: a first reactance-based evaluation (at block 910), a second reactance-based evaluation (at block 920), a third reactance-based evaluation (at block 930), and a fourth reactance-based evaluation (at block 940).

It will be appreciated that the resistance-based assessment action (at block 280) may comprise any suitable combination of resistance-based assessment processes (at blocks 282 and 800), including only one resistance-based assessment process. Additionally, the second resistance-based assessment process (at block 800) may comprise any suitable combination of resistance-based evaluations (at blocks 810-840), including only one resistance-based evaluation, as described further below with reference to FIGs 9-12.

Similarly, it shall be appreciated that the reactance-based assessment action (at block 290) may comprise any suitable combination of reactance-based assessment processes (at blocks 292 and 900), including only one reactance-based assessment process. Additionally, the second reactance-based assessment process (at block 900) may comprise any suitable combination of reactance-based evaluations (at blocks 910-940), including only one reactance-based evaluation, as described in greater detail below with reference to FIGs. 13-16.

**FIGs. 9-12** are flowcharts showing respective resistance-based evaluations shown by FIG. 7 (in blocks 810-840) in detail. Each resistance-based evaluation includes a step of comparing (at block 802) either the calculated resistance or the calculated rate of change of resistance to a threshold. Based on the comparison (at block 802), each resistance-based evaluation further includes determining (as represented by blocks 804 and 806 together) whether a compromised condition criterion has been met. In response to a positive determination (as represented by block 806) that the compromised condition criterion condition has been met, each resistance-based evaluation includes generating (at block 808) an alarm indicative of the heating arrangement 130 being in a compromised condition.

In each of the first resistance-based evaluation (in block 810) and the second resistance-based evaluation (in block 820) shown by FIGs. 9 and 10, respectively, the threshold is a resistance threshold. Therefore, each of the first resistance-based evaluation and the second resistance-based evaluation includes determining (as represented by blocks 804 and 806 together) whether the compromised condition has been met based on a comparison (at block 802) of the calculated resistance of the heating arrangement 130 to the resistance threshold.

However, in the first resistance-based evaluation shown by FIG. 9, the resistance threshold is an upper resistance threshold and the first resistance-based evaluation further includes determining (at block 806) that the compromised condition criterion has been met if the calculated resistance is greater than the upper resistance threshold. On the other hand, the first resistance-based evaluation further includes determining (at block 804) that the compromised condition criterion has not been met if the calculated resistance of the heating arrangement 130 is not greater than the upper resistance threshold.

In contrast, in the second resistance-based evaluation shown by FIG. 10, the resistance threshold is a lower resistance threshold and the first resistance-based evaluation further includes determining (at block 806) that the compromised condition criterion has been met if the calculated resistance is lower than the lower resistance threshold. Conversely, the second resistance-based evaluation further includes determining (at block 804) that the compromised condition criterion has not been met if the calculated resistance of the heating arrangement 130 is not lower than the lower resistance threshold.

Each of the third resistance-based evaluation (in block 830) and the fourth resistance-based evaluation (in block 840) shown by FIGs. 11 and 12, respectively, comprises a step of calculating (at block 801) the rate of change of the resistance of the heating arrangement 130 based on the stored information relating to the calculated resistance (as stored at block 260, see FIG. 6). In each of the third resistance-based evaluation (in block 830) and the fourth resistance-based evaluation (in block 840) the threshold is a resistance rate-of change threshold. Therefore, each of the third resistance-based evaluation and the fourth resistance-based evaluation includes determining (as represented by blocks 804 and 806 together) whether the compromised condition has been met based on a comparison (at block 802) of the calculated rate of change of resistance of the heating arrangement 130 to the resistance rate of change threshold.

More specifically, in the third resistance-based evaluation shown by FIG. 11, the resistance rate of change threshold is a resistance rate of change increase threshold and the third resistance-based evaluation further includes determining (at block 806) that the compromised condition criterion has been met if the calculated rate of change of resistance is positive (that is, the resistance of the heating arrangement 130 is increasing with time) and has a magnitude which is greater than the resistance rate of change increase threshold. To this end, the third resistance-based evaluation includes an additional step of determining whether the calculated rate of change of the resistance is positive (as represented by block 803 in FIG. 11). However, it will be appreciated that the steps represented by blocks 802 and 803 may be combined (in other words, performed simultaneously). Otherwise, the third resistance-based evaluation further includes determining (at block 804) that the compromised condition criterion has not been met if the calculated rate of change of resistance of the heating arrangement 130 is either not positive (that is, the resistance of the heating arrangement 130 is not increasing with time) or is not greater than the resistance rate of change increase threshold.

Contrastingly, in the fourth resistance-based evaluation shown by FIG. 12, the resistance rate of change threshold is a resistance rate of change decrease threshold and the fourth resistance-based evaluation further includes determining (at block 806) that the compromised condition criterion has been met if the calculated rate of change of resistance is negative (that is, the resistance of the heating arrangement 130 is decreasing with time) and has a magnitude which is greater than the resistance rate of change decrease threshold. For this purpose, the fourth resistance-based evaluation includes an additional step of determining whether the calculated rate of change of the resistance is negative (as represented by block 803 in FIG. 12). However, as discussed above with reference to FIG. 11, it will be appreciated that the steps represented by blocks 802 and 803 may be combined (in other words, performed simultaneously). On the other hand, the fourth resistance-based evaluation also includes determining (at block 804) that the compromised condition criterion has not been met if the calculated rate of change of resistance of the heating arrangement 130 is either not negative (that is, the resistance of the heating arrangement 130 is not decreasing with time) or is not greater than the resistance rate of change decrease threshold.

If the second resistance-based assessment process (in block 800) includes both the first resistance-based evaluation (at block 810) and the second resistance-based evaluation (at block 820), the upper resistance threshold is greater than the lower resistance threshold. If the second resistance-based assessment process (in block 800) includes both the third resistance-based evaluation (at block 830) and the fourth resistance-based evaluation (at block 840), the resistance rate of change increase threshold may be dissimilar (e.g. substantially not equal to) to the resistance rate of change decrease threshold. In addition, if the method 200 includes more than one of the resistance-based evaluations (at blocks 810-840) and/or any of the reactance-based evaluations (at blocks 910-940) described above, the compromised condition criterion is determined to be met if any of the resistance-based evaluations or, optionally, any of the reactance-based evaluations results in a determination that the compromised condition criterion has been met (at block(s) 806), even if the other resistance-based evaluations and/or reactance-based evaluations included in the method 200 results in a determination that the compromised condition criterion has not been met (at block(s) 804).

**FIGs. 13-16** are flowcharts showing respective reactance-based evaluations shown by FIG. 8 (in blocks 910-940) in detail. Each reactance-based evaluation is generally similar to the corresponding resistance-based evaluation described above with reference to FIGs. 9-12, with like reference numerals indicating common or similar steps. However, in the example of FIGs. 13-16, each threshold (see block 802) is a reactance threshold (e.g. an upper reactance threshold, a lower reactance threshold, a reactance rate of change increase threshold or a reactance rate of change decrease threshold) rather than a resistance threshold.

The compromised condition generally corresponds to a condition of the heating arrangement 130 in which continued operation thereof to heat the process medium 140 poses a significant risk of damage to the electrical system 101, 102, 103 and/or components external to the electrical system 101, 102, 103 (e.g. as a result of unintended conduction of electrical energy to components external to the electrical system). The alarm generated (at block 808) may include energising an alarm circuit (not shown) which alerts an operating to the heating arrangement 130 being in the compromised condition. In some examples, the alarm circuit being energised may result in may result in the heating arrangement 130 being decoupled from the power supply 110 by the switching arrangement 120. In other examples, the data processing apparatus 190 may control the switching arrangement 120 to decouple the power supply 110 from the switching arrangement 120 in response to the alarm generated (at block 808) or in response to an input provided to a human-machine interface to the system 101, 102, 103 from, for example, an operator. The operator may be prompted to provide the input to the human-machine interface to the system 101, 102, 103 by the alarm generated (at block 808). By way of example, the alarm generated (at block 808) may include an audible, visible and/or a tactile alert.

More specifically, if the resistance of the heating arrangement 130 is greater than the upper resistance threshold, the compromised condition may correspond to a severely materially corroded or materially degraded condition of the or each heating element 131A. If the rate of change of the resistance of the heating arrangement 130 is positive and has a magnitude which is greater than the resistance rate of change increase threshold, the compromised condition may correspond to a rapidly corroding or rapidly degrading material condition of the or each heating element 131A. Similarly, if the reactance of the heating arrangement 130 is greater than the upper reactance threshold, the compromised condition may correspond to a severely structurally flawed condition of the or each electrically insulating sheath 132A. Further, if the rate of change of the reactance of the heating arrangement 130 is positive and has a magnitude which is greater than the reactance rate of change increase threshold, the compromised condition may correspond to a rapidly deteriorating structural condition of the or each electrically insulating sheath 132A.

Additionally, if the resistance of the heating arrangement 130 is less than the lower resistance threshold, the compromised condition may correspond to a shorted condition of the or each heating element 131A (e.g. a short circuit across the heating element 131A or a short circuit between at least two of the heating elements 131A of respective heating components 130A-130C exists). If the rate of change of the resistance of the heating arrangement 130 is negative and has a magnitude which is greater that the resistance rate of change decrease threshold, the compromised condition may correspond to a developing shorted condition of the or each heating element 131A. Likewise, if the reactance of the heating arrangement 130 is less than the lower reactance threshold, the compromised condition may correspond to a severely structurally flawed condition of the or each electrically insulating sheath 132A. Further, if the rate of change of the reactance of the heating arrangement 130 is negative and has a magnitude which is greater that the reactance rate of change decrease threshold, the compromised condition may correspond to a rapidly deteriorating structural condition of the or each electrically insulating sheath 132A.

**FIG. 17** is a flowchart which shows a second example method 200' of assessing a condition of a heating arrangement for heating a process medium, wherein the heating arrangement forms part of a system in accordance with any of the example systems 101, 102, 103 described above with reference to FIGs. 1-5. The second example method 200' is generally similar to the first example method 200 described above with respect to FIG. 6, with like reference numerals indicating common or similar steps.

In contrast to the first example method 200, if the power supply 110 is an AC power supply 110, the second example method 200' does not include an action of calculating a reactance $X_{130}$ of the heating arrangement 130. Instead, the method 200' includes an action of storing (at block 270') information relating to the determined phase angle difference (as determined at block 230). The information relating to the determined phase angle difference includes at least a value of the determined phase angle difference, and may also include associated information such as a time at which the phase angle difference was determined.

If the method 200' includes the actions represented by each of blocks 230 and 270', the method 200' may further comprise an action of assessing (at block 290') the condition of the heating arrangement 130 based on the determined phase angle difference (as calculated at block 270'). The action represented by block 290' is referred to as a phase angle-based assessment action herein.

In further contrast to the first example method 200, the second example method 200' need not necessarily comprise the actions represented by blocks 240, 260 and/or 280. Instead, according to the second example method 200', the assessment of the condition of the heating arrangement 130 may be based solely on the determined phase angle difference (that is, at block 290').

**FIG. 18** is a flowchart which shows an example phase angle-based assessment action (in block 290') of the method 200' shown by FIG. 17 in detail. In a similar way to the resistance-based assessment action (in block 280), the phase angle-based assessment action (in block 290') comprises: a first phase angle-based assessment process (at block 292') and a second phase angle-based assessment process (at block 900').

Any of the phase angle-based assessment processes represented by blocks 292' and 900' may include a step of calculating a rate of change of the phase angle difference based on the stored information relating to the determined phase angle difference (as stored at block 270', see FIG. 17). The calculated rate of change of the phase angle difference may then be used to assess the condition of the heating arrangement 130, as described in further detail with reference to the first phase angle-based assessment process and the second phase angle-based assessment process (at blocks 292' and 900', respectively).

Like the reactance of the heating arrangement 130, the determined phase angle difference may be considered as being generally indicative of the condition of the or each electrically insulating sheath 132A (as opposed to being generally indicative of the condition of the or each heating element 131A). Therefore, the first phase angle-based assessment action (at block 292') includes inferring the condition of the or each electrically insulating sheath 132A based on the stored information relating to the determined phase angle difference (at block 270', see FIG. 17). Inferring the condition of the or each electrically insulating sheath 132A may be based on the determined phase angle difference itself and/or a calculated rate of change of the phase angle difference as discussed above. For example, the determined phase angle difference and/or the calculated rate of change of the phase angle difference may be generally indicative of the or each electrically insulating sheath 132A being structurally flawed and/or lacking structural integrity (as described with respect to FIG. 5 above).

The inferred condition of the or each electrically insulating sheath 132A may be used as a basis for carrying out appropriate maintenance to and/or scheduling timely replacement of the heating arrangement 130 (or each electrically insulating sheath 132A alone).

As described above with respect to the first example method 200, inferring the condition of the or each electrically insulating sheath 132A may by reference to a model (e.g. a physics-based model or a statistically-based model). In particular, the model may be used to estimate (at block 293') a remaining service life of the heating arrangement 130. An age (e.g. a current service age, expressed in units of time) of the heating arrangement 130 may be used by the model in conjunction with the stored information relating to determined phase angle difference to estimate the remaining service life of the heating arrangement 130. The estimated remaining service life of the heating arrangement 130 may be displayed on a human-machine interface to the system 101, 102, 103 and/or transmitted to an external system (e.g. a remote server or a remote computational device) from which the information may be subsequently accessed by an external data processing apparatus via a wired or wireless connection.

The second phase angle-based assessment process (represented by block 900') generally includes determining whether a compromised condition criterion has been met based on the stored information relating to the determined phase angle difference (at block 270', see FIG. 17) and generating an alarm indicative of the heating arrangement 130 being in a compromised condition in response to a determination that the compromised condition criterion has been met, as explained in further detail below with reference to FIGs. 19-22. For this purpose, the second phase angle-based assessment process (as represented by block 900') includes one or more phase angle-based evaluations. In the example of FIG. 8, the second phase angle-based assessment process includes: a first phase angle-based evaluation (at block 910'), a second phase angle-based evaluation (at block 920'), a third phase angle-based evaluation (at block 930'), and a fourth phase angle-based evaluation (at block 940').

**FIGs. 19-22** are flowcharts showing respective phase angle-based evaluations shown by FIG. 18 (in blocks 910'-940') in detail. Each phase angle-based evaluation is generally similar to the corresponding reactance-based evaluation described above with reference to FIGs. 13-16, with corresponding reference numerals differentiated by the prime (') symbol indicating corresponding steps. However, in the example of FIGs. 19-22, each threshold (see block 802') is a phase angle threshold (e.g. an upper phase angle threshold, a lower phase angle threshold, a phase angle rate of change increase threshold or a phase angle rate of change decrease threshold) rather than a reactance threshold.

Any of the upper resistance threshold, the lower resistance threshold, the resistance rate of change increase threshold, the resistance rate of change decrease threshold, the upper reactance threshold, the lower reactance threshold, the reactance rate of change increase threshold, the reactance rate of change decrease threshold, the upper phase angle threshold, the lower phase angle threshold, the phase angle rate of change increase threshold and the phase angle rate of change decrease threshold may be a predetermined threshold which is determined based on a wired or wireless signal from an external system (e.g. a remote server or a remote computational device) or an input applied to or provided to a human-machine interface to the system 101, 102, 103. Further, this disclosure anticipates that each threshold may be adjusted based on the signal from the external system or an input to the human-interface to the system 101, 102, 103. In some examples threshold may be expressed in terms of a fraction or a percentage of a designed/manufactured resistance or a designed/manufactured reactance, as appropriate, of the heating arrangement 130. In other examples, each threshold may be expressed in terms of an absolute value.

**FIG. 23** highly schematically shows a data processing apparatus 410 comprising a controller 190 adapted to perform the method 200 described above with reference to FIGs. 6-22. The controller 190 may have any of the features of the controller 190 described above with respect to FIGs. 1-3. **FIG. 24** highly schematically shows a machine-readable medium 500 having stored thereon a computer program 501 comprising instructions which, when executed by a data processing apparatus (e.g. the data processing apparatus 410 described above with reference to FIG. 23), cause the data processing apparatus to execute the method 200 described above with reference to FIGs. 6-22.

The controller 190 described herein may comprise a processor. The controller or processor may comprise: at least one application specific integrated circuit (ASIC); and/or at least one field programmable gate array (FPGA); and/or single or multiprocessor architectures; and/or sequential (Von Neumann)/parallel architectures; and/or at least one programmable logic controllers (PLCs); and/or at least one microprocessor; and/or at least one microcontroller; and/or a central processing unit (CPU), to the stated functions for which the controller or processor is configured.

Except where mutually exclusive, a feature described in relation to any one of the above aspects may be applied mutatis mutandis to any other aspect. Furthermore, except where mutually exclusive, any feature described herein may be applied to any aspect and/or combined with any other feature described herein.

The numbered clauses below set out aspects of the present disclosure.

1. A method of assessing a condition of a heating arrangement for heating a process medium, the method comprising:

monitoring a voltage supplied to the heating arrangement by a power supply using a voltage sensing arrangement;
monitoring a current drawn by the heating arrangement using a current sensing arrangement;
storing information relating to the monitored current and the monitored voltage; and
assessing the condition of the heating arrangement based on the stored information relating to the monitored current and the monitored voltage.

2. The method of clause 1, wherein the heating arrangement comprises a heating component which includes a heating element, and wherein
assessing the condition of the heating arrangement based on the stored information relating to the monitored current and the monitored voltage includes:
inferring a condition of the heating element based on the stored information relating to the monitored current and the monitored voltage.

3. The method of clause 2, wherein
inferring the condition of the heating element based on the stored information relating to the monitored current and the monitored voltage includes:
estimating a remaining service life of the heating arrangement based on the stored information relating to the monitored current and the monitored voltage.

4. The method of any of the preceding clauses , wherein the heating arrangement comprises a heating component which includes a heating element at least partially surrounded by an electrically insulating sheath, and wherein
assessing the condition of the heating arrangement based on the stored information relating to the monitored current and the monitored voltage includes:
inferring a condition of the electrically insulating sheath based on the stored information relating to the calculated reactance.

5. The method of clause 4, wherein
inferring the condition of the electrically insulating sheath based on the stored information relating to the monitored current and the monitored voltage includes:
estimating a remaining service life of the heating arrangement based on the stored information relating to the monitored current and the monitored voltage.

6. The method of any of the preceding clauses, wherein the condition of the heating arrangement is associated with:

a structural integrity of the heating arrangement;
a material degradation of the heating arrangement; and/or
a material corrosion of the heating arrangement.

7. The method of any of the preceding clauses , wherein assessing the condition of the heating arrangement includes determining whether a compromised condition criterion has been met and generating an alarm indicative of the heating arrangement being in a compromised condition in response to a determination that the compromised condition criterion has been met.

**8.** A system comprising:

a heating arrangement for heating a process medium;
a voltage sensing arrangement;
a current sensing arrangement; and
a data processing apparatus configured to assess a condition of the heating arrangement in accordance with the method of any of the preceding clauses.

**9.** A machine-readable storage medium having stored thereon instructions which, when executed by a data processing apparatus, cause the data processing apparatus to carry out the method of any of the preceding clauses .

**10.** A method of assessing a condition of a heating arrangement for heating a process medium, the method comprising:

monitoring a voltage supplied to the heating arrangement by a power supply using a voltage sensing arrangement;
monitoring a current drawn by the heating arrangement using a current sensing arrangement;
calculating a resistance of the heating arrangement based on the monitored current and the monitored voltage;
storing information relating to the calculated resistance of the heating arrangement; and
assessing the condition of the heating arrangement based on the stored information relating to the calculated resistance.

**11.** The method of clause 10, wherein the heating arrangement comprises a heating component which includes a heating element, and wherein
assessing the condition of the heating arrangement based on the stored information relating to the calculated resistance includes:
inferring a condition of the heating element based on the stored information relating to the calculated resistance.

**12.** The method of clause 11, wherein
inferring the condition of the heating element based on the stored information relating to the calculated resistance includes:
estimating a remaining service life of the heating arrangement based on the stored information relating to the calculated resistance.

**13.** The method of clause 10, wherein
assessing the condition of the heating arrangement based on the stored information relating to the calculated resistance includes:

calculating a rate of change of the resistance of the heating arrangement based on the stored information relating to the calculated resistance; and
analysing the calculated rate of change of the resistance of the heating arrangement to assess the condition of the heating arrangement.

**14.** The method of clause 10, wherein

assessing the condition of the heating arrangement based on the stored information relating to the calculated resistance includes:

comparing the calculated resistance of the heating arrangement to an upper resistance threshold; and
determining that a compromised condition criterion has been met if the calculated resistance is greater than the upper resistance threshold, and/or

assessing the condition of the heating arrangement based on the stored information relating to the calculated resistance includes:

comparing the calculated resistance of the heating arrangement to a lower resistance threshold; and determining that a compromised condition criterion has been met if the calculated resistance is less than the lower resistance threshold.

**15.** The method of clause 11, wherein

analysing the calculated rate of change of the resistance of the heating arrangement to assess the condition of the heating arrangement includes:

comparing the calculated rate of change of the resistance of the heating arrangement to a resistance rate of change increase threshold; and
determining that a compromised condition criterion has been met if the calculated rate of change of resistance is positive and has a magnitude which is greater than the resistance rate of change increase threshold, and/or

analysing the calculated rate of change of the resistance of the heating arrangement to assess the condition of the heating arrangement includes:

comparing the calculated rate of change of the resistance of the heating arrangement to a resistance rate of change decrease threshold; and
determining that a compromised condition criterion has been met if the calculated rate of change of resistance is negative and has a magnitude which is greater than the resistance rate of change decrease threshold.

**16.** The method of any of clauses 10- 15, comprising:

determining a phase angle difference between the monitored current and the monitored voltage;
calculating the resistance of the heating arrangement based on the monitored current, the monitored voltage and the determined phase angle difference;
calculating a reactance of the heating arrangement based on the determined phase angle difference and the calculated resistance;
storing information relating to the calculated reactance of the heating arrangement; and
assessing the condition of the heating arrangement based on the stored information relating to the calculated reactance.

**17.** The method of clause 16, wherein the heating arrangement comprises a heating component which includes a heating element at least partially surrounded by an electrically insulating sheath, and wherein
assessing the condition of the heating arrangement based on the stored information relating to the calculated reactance includes:
inferring a condition of the electrically insulating sheath based on the stored information relating to the calculated reactance.

**18.** The method of clause 17, wherein
inferring the condition of the electrically insulating sheath based on the stored information relating to the calculated reactance includes:
estimating a remaining service life of the heating arrangement based on the stored information relating to the calculated reactance.

**19.** The method of any of clauses 16 - 18, wherein
assessing the condition of the heating arrangement based on the stored information relating to the calculated reactance includes:

calculating a rate of change of the reactance of the heating arrangement based on the stored information relating to the calculated reactance; and
analysing the calculated rate of change of the reactance of the heating arrangement to assess the condition of the heating arrangement.

**20.** The method of any of clauses 16 - 18, wherein

assessing the condition of the heating arrangement based on the stored information relating to the calculated reactance includes:

comparing the calculated reactance of the heating arrangement to an upper reactance threshold; and determining that a compromised condition criterion has been met if the calculated reactance is greater than the upper reactance threshold, and/or

assessing the condition of the heating arrangement based on the stored information relating to the calculated reactance includes:

comparing the calculated reactance of the heating arrangement to a lower reactance threshold; and determining that a compromised condition criterion has been met if the calculated reactance is less than the lower reactance threshold.

21. The method of clause 19, wherein

analysing the calculated rate of change of the reactance of the heating arrangement to assess the condition of the heating arrangement includes:

comparing the calculated rate of change of the reactance of the heating arrangement to a reactance rate of change increase threshold; and determining that a compromised condition criterion has been met if the calculated rate of change of reactance is positive and has a magnitude which is greater than the reactance rate of change increase threshold, and/or

analysing the calculated rate of change of the reactance of the heating arrangement to assess the condition of the heating arrangement includes:

comparing the calculated rate of change of the reactance of the heating arrangement to a reactance rate of change decrease threshold; and determining that a compromised condition criterion has been met if the calculated rate of change of reactance is negative and has a magnitude which is greater than the reactance rate of change decrease threshold.

22. The method of any of clauses 10 - 21, wherein the condition of the heating arrangement is associated with:

a structural integrity of the heating arrangement;
a material degradation of the heating arrangement; and/or
a material corrosion of the heating arrangement.

23. The method of any of clauses 10 - 22, wherein assessing the condition of the heating arrangement includes determining whether a compromised condition criterion has been met and generating an alarm indicative of the heating arrangement being in a compromised condition in response to a determination that the compromised condition criterion has been met.

24. A system comprising:

a heating arrangement for heating a process medium;
a voltage sensing arrangement;
a current sensing arrangement; and
a data processing apparatus configured to assess a condition of the heating arrangement in accordance with the method of any of clauses 10 - 23.

25. A machine-readable storage medium having stored thereon instructions which, when executed by a data processing apparatus, cause the data processing apparatus to carry out the method of any of clauses 10 - 23.

26. A method of assessing a condition of a heating arrangement for heating a process medium, the method comprising:

monitoring a voltage supplied to the heating arrangement by a power supply using a voltage sensing arrangement;

monitoring a current drawn by the heating arrangement using a current sensing arrangement;
determining a phase angle difference between the monitored current and the monitored voltage;
storing information relating to the determined phase angle difference; and
assessing the condition of the heating arrangement based on the stored information relating to the determined phase angle difference.

**27.** The method of clause 26, wherein the heating arrangement comprises a heating component which includes a heating element at least partially surrounded by an electrically insulating sheath, and wherein
assessing the condition of the heating arrangement based on the stored information relating to the determined phase angle difference includes:
inferring a condition of the electrically insulating sheath based on the stored information relating to the determined phase angle difference.

**28.** The method of clause 27, wherein
inferring the condition of the electrically insulating sheath based on the stored information relating to the determined phase angle difference includes:
estimating a remaining service life of the heating arrangement based on the stored information relating to the determined phase angle difference.

**29.** The method of clause 26, wherein
assessing the condition of the heating arrangement based on the stored information relating to the determined phase angle difference includes:

calculating a rate of change of the phase angle difference; and
analysing the calculated rate of change of the phase angle difference to assess the condition of the heating arrangement.

**30.** The method of clause 29, wherein

assessing the condition of the heating arrangement based on the stored information relating to the determined phase angle difference includes:

comparing the determined phase angle difference to an upper phase angle threshold; and
determining that a compromised condition criterion has been met if the determined phase angle difference is greater than the upper phase angle threshold, and/or

assessing the condition of the heating arrangement based on the stored information relating to the determined phase angle difference includes:

comparing the determined phase angle difference to a lower phase angle threshold; and
determining that a compromised condition criterion has been met if the determined phase angle difference is less than the lower phase angle threshold.

**31.** The method of clause 29, wherein
analysing the calculated rate of change of the phase angle difference to assess the condition of the heating arrangement includes:

comparing the calculated rate of change of the phase angle difference to a phase angle rate of change increase threshold; and
determining that a compromised condition criterion has been met if the calculated rate of change of phase angle difference is positive and has a magnitude which is greater than the phase angle rate of change increase threshold, and/or
analysing the calculated rate of change of the reactance of the phase angle difference to assess the condition of the heating arrangement includes:

comparing the calculated rate of change of the reactance of the phase angle difference to a phase angle rate of change decrease threshold; and
determining that a compromised condition criterion has been met if the calculated rate of change of phase angle difference is negative and has a magnitude which is greater than the phase angle rate of change decrease threshold.

32. The method of any of clauses 26 - 31, wherein the condition of the heating arrangement is associated with:

a structural integrity of the heating arrangement;
a material degradation of the heating arrangement; and/or
a material corrosion of the heating arrangement.

33. The method of any of clauses 26 - 32, wherein assessing the condition of the heating arrangement includes determining whether a compromised condition criterion has been met and generating an alarm indicative of the heating arrangement being in a compromised condition in response to a determination that the compromised condition criterion has been met.

34. A system comprising:

a heating arrangement for heating a process medium;
a voltage sensing arrangement;
a current sensing arrangement; and
a data processing apparatus configured to assess a condition of the heating arrangement in accordance with the method of any of clauses claim 27.

35. A machine-readable storage medium having stored thereon instructions which, when executed by a data processing apparatus, cause the data processing apparatus to carry out the method of any of clauses 26 - 33.

**Claims**

1. A method of assessing a condition of a heating arrangement for heating a process medium, the method comprising:

monitoring a voltage supplied to the heating arrangement by a power supply using a voltage sensing arrangement;
monitoring a current drawn by the heating arrangement using a current sensing arrangement;
storing information relating to the monitored current and the monitored voltage; and
assessing the condition of the heating arrangement based on the stored information relating to the monitored current and the monitored voltage.

2. The method of claim 1, wherein the heating arrangement comprises a heating component which includes a heating element, and wherein
assessing the condition of the heating arrangement based on the stored information relating to the monitored current and the monitored voltage includes:
inferring a condition of the heating element based on the stored information relating to the monitored current and the monitored voltage.

3. The method of claim 2, wherein
inferring the condition of the heating element based on the stored information relating to the monitored current and the monitored voltage includes:
estimating a remaining service life of the heating arrangement based on the stored information relating to the monitored current and the monitored voltage.

4. The method of claim 1, wherein the heating arrangement comprises a heating component which includes a heating element at least partially surrounded by an electrically insulating sheath, and wherein
assessing the condition of the heating arrangement based on the stored information relating to the monitored current and the monitored voltage includes:
inferring a condition of the electrically insulating sheath based on the stored information relating to the monitored current and the monitored voltage.

5. The method of claim 4, wherein

inferring the condition of the electrically insulating sheath based on the stored information relating to the monitored current and the monitored voltage includes:
estimating a remaining service life of the heating arrangement based on the stored information relating to the monitored current and the monitored voltage.

**6.** The method of any of the preceding claims, comprising:

calculating a resistance of the heating arrangement based on the monitored current and the monitored voltage;
storing information relating to the calculated resistance of the heating arrangement; and
assessing the condition of the heating arrangement based on the stored information relating to the calculated resistance.

**7.** The method of claim 6, wherein
assessing the condition of the heating arrangement based on the stored information relating to the calculated resistance includes:

calculating a rate of change of the resistance of the heating arrangement based on the stored information relating to the calculated resistance; and
analysing the calculated rate of change of the resistance of the heating arrangement to assess the condition of the heating arrangement.

**8.** The method of claim 6, wherein

assessing the condition of the heating arrangement based on the stored information relating to the calculated resistance includes:

comparing the calculated resistance of the heating arrangement to an upper resistance threshold; and
determining that a compromised condition criterion has been met if the calculated resistance is greater than the upper resistance threshold, and/or

assessing the condition of the heating arrangement based on the stored information relating to the calculated resistance includes:

comparing the calculated resistance of the heating arrangement to a lower resistance threshold; and
determining that a compromised condition criterion has been met if the calculated resistance is less than the lower resistance threshold.

**9.** The method of claim 7, wherein

analysing the calculated rate of change of the resistance of the heating arrangement to assess the condition of the heating arrangement includes:

comparing the calculated rate of change of the resistance of the heating arrangement to a resistance rate of change increase threshold; and
determining that a compromised condition criterion has been met if the calculated rate of change of resistance is positive and has a magnitude which is greater than the resistance rate of change increase threshold, and/or

analysing the calculated rate of change of the resistance of the heating arrangement to assess the condition of the heating arrangement includes:

comparing the calculated rate of change of the resistance of the heating arrangement to a resistance rate of change decrease threshold; and
determining that a compromised condition criterion has been met if the calculated rate of change of resistance is negative and has a magnitude which is greater than the resistance rate of change decrease threshold.

**10.** The method of claim 6, comprising:

determining a phase angle difference between the monitored current and the monitored voltage;

calculating the resistance of the heating arrangement based on the monitored current, the monitored voltage and the determined phase angle difference;

calculating a reactance of the heating arrangement based on the determined phase angle difference and the calculated resistance;

storing information relating to the calculated reactance of the heating arrangement; and

assessing the condition of the heating arrangement based on the stored information relating to the calculated reactance.

11. The method of claim 10, wherein

assessing the condition of the heating arrangement based on the stored information relating to the calculated reactance includes:

calculating a rate of change of the reactance of the heating arrangement based on the stored information relating to the calculated reactance; and

analysing the calculated rate of change of the reactance of the heating arrangement to assess the condition of the heating arrangement.

12. The method of claim 8, wherein

assessing the condition of the heating arrangement based on the stored information relating to the calculated reactance includes:

comparing the calculated reactance of the heating arrangement to an upper reactance threshold; and

determining that a compromised condition criterion has been met if the calculated reactance is greater than the upper reactance threshold, and/or

assessing the condition of the heating arrangement based on the stored information relating to the calculated reactance includes:

comparing the calculated reactance of the heating arrangement to a lower reactance threshold; and

determining that a compromised condition criterion has been met if the calculated reactance is less than the lower reactance threshold.

13. The method of claim 11, wherein

analysing the calculated rate of change of the reactance of the heating arrangement to assess the condition of the heating arrangement includes:

comparing the calculated rate of change of the reactance of the heating arrangement to a reactance rate of change increase threshold; and

determining that a compromised condition criterion has been met if the calculated rate of change of reactance is positive and has a magnitude which is greater than the reactance rate of change increase threshold, and/or

analysing the calculated rate of change of the reactance of the heating arrangement to assess the condition of the heating arrangement includes:

comparing the calculated rate of change of the reactance of the heating arrangement to a reactance rate of change decrease threshold; and

determining that a compromised condition criterion has been met if the calculated rate of change of reactance is negative and has a magnitude which is greater than the reactance rate of change decrease threshold.

14. The method of claim 1, comprising:

determining a phase angle difference between the monitored current and the monitored voltage;

storing information relating to the determined phase angle difference; and

assessing the condition of the heating arrangement based on the stored information relating to the determined phase angle difference.

**15.** The method of claim 14, wherein
assessing the condition of the heating arrangement based on the stored information relating to the determined phase angle difference includes:

calculating a rate of change of the phase angle difference; and
analysing the calculated rate of change of the phase angle difference to assess the condition of the heating arrangement.

**16.** The method of claim 14, wherein

assessing the condition of the heating arrangement based on the stored information relating to the determined phase angle difference includes:

comparing the determined phase angle difference to an upper phase angle threshold; and
determining that a compromised condition criterion has been met if the determined phase angle difference is greater than the upper phase angle threshold, and/or

assessing the condition of the heating arrangement based on the stored information relating to the determined phase angle difference includes:

comparing the determined phase angle difference to a lower phase angle threshold; and
determining that a compromised condition criterion has been met if the determined phase angle difference is less than the lower phase angle threshold.

**17.** The method of claim 15, wherein

analysing the calculated rate of change of the phase angle difference to assess the condition of the heating arrangement includes:

comparing the calculated rate of change of the phase angle difference to a phase angle rate of change increase threshold; and
determining that a compromised condition criterion has been met if the calculated rate of change of phase angle difference is positive and has a magnitude which is greater than the phase angle rate of change increase threshold, and/or

analysing the calculated rate of change of the reactance of the phase angle difference to assess the condition of the heating arrangement includes:

comparing the calculated rate of change of the reactance of the phase angle difference to a phase angle rate of change decrease threshold; and
determining that a compromised condition criterion has been met if the calculated rate of change of phase angle difference is negative and has a magnitude which is greater than the phase angle rate of change decrease threshold.

**18.** The method of any of the preceding claims, wherein the condition of the heating arrangement is associated with:

a structural integrity of the heating arrangement;
a material degradation of the heating arrangement; and/or
a material corrosion of the heating arrangement.

**19.** The method of any of the preceding claims, wherein assessing the condition of the heating arrangement includes determining whether a compromised condition criterion has been met and generating an alarm indicative of the heating arrangement being in a compromised condition in response to a determination that the compromised condition criterion has been met.

**20.** A system comprising:

a heating arrangement for heating a process medium;

a voltage sensing arrangement;
a current sensing arrangement; and
a data processing apparatus configured to assess a condition of the heating arrangement in accordance with the method of any of the preceding claims.

**FIG. 1**

EP 4 447 612 A1

FIG. 2

**FIG. 3**

103
140
184
182
130
130A
190
120
120A
150
150A
110

FIG. 4

FIG. 5

EP 4 447 612 A1

200

210 — monitor voltage supplied to heating arrangement by power supply

220 — monitor current drawn by heating arrangement

230 — determine phase angle difference between monitored voltage and monitored current

240 — calculate resistance of heating arrangement

250 — calculate reactance of heating arrangement

260 — store information relating to calculated resistance

270 — store information relating to calculated reactance

280 — assess condition of heating arrangement based on calculated resistance

290 — assess condition of heating arrangement based on calculated reactance

*FIG. 6*

280

282

infer condition of heating element based on stored information relating to calculated resistance

283

estimate remaining service life of heating arrangement

800

determine whether compromised condition criterion has been met

810

first resistance -based evaluation

820

second resistance -based evaluation

830

third resistance -based evaluation

840

fourth resistance -based evaluation

**FIG. 7**

290

292

infer condition of heating element based on stored information relating to calculated reactance

293

estimate remaining service life of heating arrangement

900

determine whether compromised condition criterion has been met

910

first reactance -based evaluation

920

second reactance -based evaluation

930

third reactance -based evaluation

940

fourth reactance -based evaluation

**FIG. 8**

810

802

is calculated resistance greater than upper threshold?

YES

NO

804

compromised condition criterion not met

compromised condition criterion met

806

808

generate alarm indicative of heating arrangement being in compromised condition

**FIG. 9**

820

802

is calculated resistance less than lower threshold?

YES

NO

804

compromised condition criterion not met

compromised condition criterion met

806

808

generate alarm indicative of heating arrangement being in compromised condition

**FIG. 10**

830

calculate rate of change of resistance of heating arrangement

802 / \ 801

does calculated rate of change of resistance have a magnitude which is greater than increase threshold?

YES

NO

is calculated rate of change of resistance positive?

803

NO

YES

compromised condition criterion not met

804

compromised condition criterion met

806

808

generate alarm indicative of heating arrangement being in compromised condition

**FIG. 11**

840

calculate rate of change of resistance of heating arrangement

802 / \ 801

does calculated rate of change of resistance have a magnitude which is greater than decrease threshold?

YES

NO

is calculated rate of change of resistance negative?

803

NO

YES

compromised condition criterion not met

804

compromised condition criterion met

806

808

generate alarm indicative of heating arrangement being in compromised condition

**FIG. 12**

**910**

**802**

is calculated reactance greater than upper threshold?

**NO**

**804**

**YES**

compromised condition criterion not met

compromised condition criterion met

**806**

**808**

generate alarm indicative of heating arrangement being in compromised condition

**FIG. 13**

**920**

**802**

is calculated reactance less than lower threshold?

**NO**

**804**

**YES**

compromised condition criterion not met

compromised condition criterion met

**806**

**808**

generate alarm indicative of heating arrangement being in compromised condition

**FIG. 14**

930 ⌇

calculate rate of change of
reactance of heating
arrangement

802 ⌇    ⌇ 801

does calculated rate of
change of reactance
have a magnitude
which is greater than
increase threshold?

YES                              NO

is calculated
rate of
change of                ⌇ 803
reactance
positive?         NO

YES

compromised
condition
criterion not met

804 ⌇

compromised
condition             ⌇ 806
criterion met

808 ⌇

generate alarm indicative of
heating arrangement being in
compromised condition

940 ⌇

calculate rate of change of
reactance of heating
arrangement

802 ⌇    ⌇ 801

does calculated rate of
change of reactance
have a magnitude
which is greater than
decrease threshold?

YES                              NO

is calculated
rate of
change of                ⌇ 803
reactance
negative?         NO

YES

compromised
condition
criterion not met

804 ⌇

compromised
condition             ⌇ 806
criterion met

808 ⌇

generate alarm indicative of
heating arrangement being in
compromised condition

**FIG. 15**                    **FIG. 16**

200'

210 — monitor voltage supplied to heating arrangement by power supply

220 — monitor current drawn by heating arrangement

230 — determine phase angle difference between monitored voltage and monitored current

240 — calculate resistance of heating arrangement

260 — store information relating to calculated resistance

270' — store information relating to determined phase angle difference

280 — assess condition of heating arrangement based on calculated resistance

290' — assess condition of heating arrangement based on determined phase angle

## FIG. 17

**FIG. 18**

910' ⌁

802 ⌁

is calculated reactance greater than upper threshold?

NO

804 ⌁

YES

compromised condition criterion not met

compromised condition criterion met

806

808 ⌁

generate alarm indicative of heating arrangement being in compromised condition

**FIG. 19**

920' ⌁

802 ⌁

is calculated reactance less than lower threshold?

NO

804 ⌁

YES

compromised condition criterion not met

compromised condition criterion met

806

808 ⌁

generate alarm indicative of heating arrangement being in compromised condition

**FIG. 20**

930' —

calculate rate of change of reactance of heating arrangement

802 —         \—— 801

does calculated rate of change of reactance have a magnitude which is greater than increase threshold?

*YES*                          *NO*

is calculated rate of change of reactance positive?     —— 803

                *NO*

*YES*

compromised condition criterion not met

                    804 —

compromised condition criterion met    —— 806

808 —

generate alarm indicative of heating arrangement being in compromised condition

**FIG. 21**

940' —

calculate rate of change of reactance of heating arrangement

802 —         \—— 801

does calculated rate of change of reactance have a magnitude which is greater than decrease threshold?

*YES*                          *NO*

is calculated rate of change of reactance negative?     —— 803

                *NO*

*YES*

compromised condition criterion not met

                    804 —

compromised condition criterion met    —— 806

808 —

generate alarm indicative of heating arrangement being in compromised condition

**FIG. 22**

**FIG. 23**

**FIG. 24**

EP 4 447 612 A1

Europäisches
Patentamt

European
Patent Office

Office européen
des brevets

# EUROPEAN SEARCH REPORT

Application Number

EP 24 16 5440

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/125764 A1 (KNOEPPEL RAY O [US] ET AL) 7 June 2007 (2007-06-07) | 1-5, 18-20 | INV. H05B1/02 |
| A | * paragraph [0001] * <br> * paragraph [0021]; figures 1,2 * <br> * paragraph [0025]; figure 3 * <br> * paragraph [0027]; figure 3 * | 10-13 | |
| X | US 2019/128461 A1 (PIONETTI FRANÇOIS-RÉGIS [FR] ET AL) 2 May 2019 (2019-05-02) | 1,6, 14-17,20 | |
| A | * paragraph [0001] * <br> * paragraph [0053] - paragraph [0054]; figure 1 * <br> * paragraph [0064] * | 10-13 | |
| X | US 2021/195948 A1 (BILAT STEPHANE [CH] ET AL) 1 July 2021 (2021-07-01) | 1,6-9,20 | |
| A | * paragraph [0001] * <br> * paragraph [0047] * <br> * paragraph [0069] * <br> * paragraph [0104] - paragraph [0105]; figures 4,5 * | 10-13 | |

TECHNICAL FIELDS
SEARCHED (IPC)

H05B

The present search report has been drawn up for all claims

| Place of search | Date of completion of the search | Examiner |
|---|---|---|
| Munich | 26 August 2024 | Barzic, Florent |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.......................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 16 5440

This annex lists the patent family members relating to the patent documents cited in the above-mentioned European search report.
The members are as contained in the European Patent Office EDP file on
The European Patent Office is in no way liable for these particulars which are merely given for the purpose of information.

26-08-2024

| Patent document cited in search report | Publication date | Patent family member(s) | Publication date |
|---|---|---|---|
| US 2007125764 A1 | 07-06-2007 | CN 1991272 A | 04-07-2007 |
|  |  | US 2007125764 A1 | 07-06-2007 |
| US 2019128461 A1 | 02-05-2019 | BR 112018070862 A2 | 05-02-2019 |
|  |  | EP 3446540 A1 | 27-02-2019 |
|  |  | FR 3050356 A1 | 20-10-2017 |
|  |  | US 2019128461 A1 | 02-05-2019 |
|  |  | WO 2017182721 A1 | 26-10-2017 |
| US 2021195948 A1 | 01-07-2021 | BR 112020022023 A2 | 02-02-2021 |
|  |  | CN 112087958 A | 15-12-2020 |
|  |  | EP 3801084 A1 | 14-04-2021 |
|  |  | EP 4056057 A1 | 14-09-2022 |
|  |  | EP 4393335 A2 | 03-07-2024 |
|  |  | IL 278621 A | 01-03-2021 |
|  |  | JP 7449240 B2 | 13-03-2024 |
|  |  | JP 2021526015 A | 30-09-2021 |
|  |  | JP 2024052927 A | 12-04-2024 |
|  |  | KR 20210016367 A | 15-02-2021 |
|  |  | PH 12020551967 A1 | 13-09-2021 |
|  |  | PL 3801084 T3 | 24-10-2022 |
|  |  | US 2021195948 A1 | 01-07-2021 |
|  |  | US 2024081425 A1 | 14-03-2024 |
|  |  | WO 2019229112 A1 | 05-12-2019 |

EPO FORM P0459

For more details about this annex : see Official Journal of the European Patent Office, No. 12/82